# EUROPEAN PATENT APPLICATION

(11) **EP 1 708 270 A2**
(43) Date of publication of application: **04.10.2006**
(21) Application number: 06006599.2
(22) Date of filing: 29.03.2006
(51) Int. Cl.: H01L 27/148, H01L 27/146

(54) **Solid-state imaging device and manufacture thereof**

(30) Priority: 01.04.2005 JP 2005106681
(71) Applicant: MATSUSHITA ELECTRIC INDUSTRIAL CO., LTD., Kadoma-shi, Osaka 571-8501 (JP)
(72) Inventor: Yamada, Tooru, Tokyo 146-0092 (JP)
(74) Representative: Schorr, Frank Jürgen

(57) **Abstract**

In a solid-state imaging device including a semiconductor substrate in which photoelectric conversion parts 11a, vertical CCDs 2, and a vertical bus line part 16 are provided, the vertical CCDs 2 are provided with transfer channels 2a, first vertical transfer electrodes 6, second vertical transfer electrodes 9, and shielding films 13. The first transfer electrodes 6 and the second transfer electrodes 9 are arranged so that, in regions where the transfer channels 2a are not formed, the second transfer electrodes 9 are positioned above the first transfer electrodes 6, while in regions where the transfer channels 2a are formed, the first and second transfer electrodes 6 and 9 are arranged so as to be adjoined to each other, and portions of the second transfer electrodes 9 in the regions where the transfer channels 2a are formed do not overlap the first transfer electrodes 9 in the thickness direction of the semiconductor substrate.

## Description

The present invention relates to a solid-state imaging device and a method for manufacturing the same.

In recent years, the demand for solid-state imaging devices has increased rapidly due to the rapidly widespread use of digital cameras and digital movie cameras, as well as camera cellular phones. Particularly recently, solid-state imaging devices driven at a high speed have been demanded, for compatibility with images with increased number of pixels and moving images. As one of the solutions to cope with such demands, the shunt wiring structure has been known, in which shielding films also have a function of feeding transfer pulses to transfer electrodes in vertical charge coupled devices (CCDs) (see JP10(1998)-223881A, for instance).

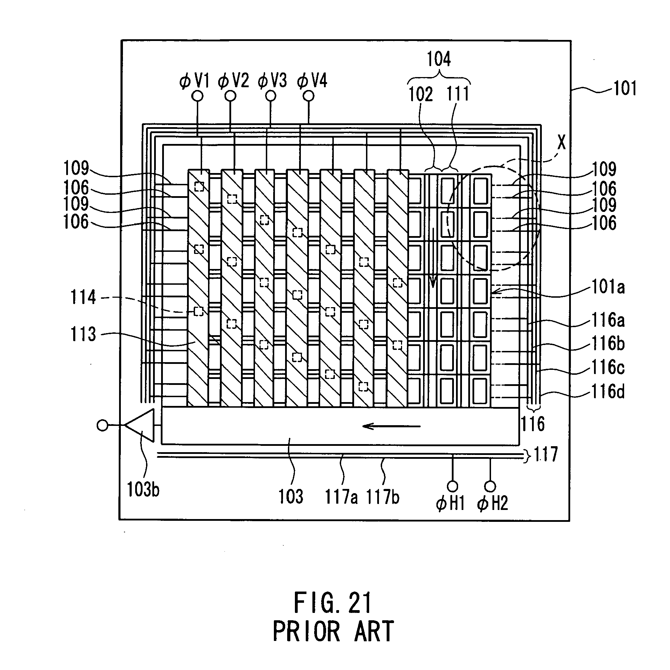

An example of a solid-state imaging device having a shunt wiring structure (conventional example 1) is described with reference to FIGS. 21 to 29. First, an overall configuration of the solid-state imaging device is described. FIG. 21 is a schematice view illustrating an overall configuration of a solid-state imaging device having a shunt wiring structure of the prior art. As shown in FIG. 21, the solid-state imaging device is formed by arranging a plurality of pixels 104 in a matrix on a photo-detective region 101a on a semiconductor substrate 101. Examples of the semiconductor substrate 101 include a silicon substrate.

Further, interline transfer is adopted in the solid-state imaging device shown in FIG. 21, and each pixel is provided with a vertical CCD 102 and a photo diode part 111. On the semiconductor substrate 101, a horizontal CCD 103 is formed to be adjacent to the vertical CCDs 102 at the end row. At an output end of the horizontal CCD 103, an output amplifier 103b is provided. The vertical CCDs 102 and the horizontal CCD 103 function as charge transfer devices. Arrows in FIG. 21 indicate directions in which charges are transferred.

Though not shown in FIG. 21, each of the vertical CCDs 102 and the horizontal CCD 103 is provided with a transfer channel, first transfer electrodes, and second transfer electrodes. It should be noted that in the present specification, the transfer electrodes of the vertical CCD are referred to as "vertical transfer electrodes", and the transfer electrodes of the horizontal CCD are referred to as "horizontal transfer electrodes".

In a region surrounding the photo-detective region 101a, a vertical bus line part 116 is provided to extend along the outline of the photo-detective region 101a. The vertical bus line part 116 includes vertical bus line wires 116a to 116d. Different transfer pulses ΦV1 to ΦV4 are fed from outside to the vertical bus line wires 116a to 116d, respectively. On a side of the horizontal CCD 103 opposite to the vertical CCDs (the bottom side in the drawing), a horizontal bus line part 117 is provided to extend along the horizontal CCD 103. The horizontal bus line part 117 includes the horizontal bus line wires 117a and 117b. Different transfer pulses ΦH1 and ΦH2 are fed from outside to the horizontal bus line wires 117a and 117b, respectively.

Further, in order to prevent light from being incident on the vertical CCDs 102, a plurality of shielding films 113 provided in a stripe form are formed so that each line of the shielding films 113 covers each column of the vertical CCD 102. The shielding films 113 are formed of a metal material, and each shielding film 113 is connected with one of the vertical bus line wires 116a to 116d. The shielding films 113 also are connected with the vertical transfer electrodes via contact holes 114, respectively. Therefore, the shielding films 113 also function as shunt wiring for feeding the transfer pulses to the transfer electrodes of the vertical CCDs 102. It should be noted that in FIG. 21, the illustration of a part of the shielding films 113 is omitted.

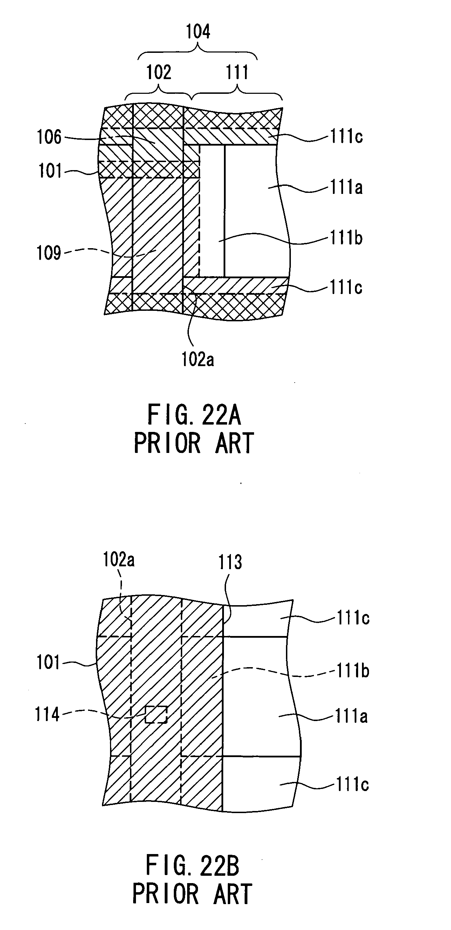

The following specifically describes a configuration of the pixel of the solid-state imaging device shown in FIG. 21 while referring to FIGS. 22A and 22B. FIGS. 22A and 22B are enlarged views illustrating the configuration of the pixel of the solid-state imaging device shown in FIG. 21. FIG. 22A shows a configuration below the shielding film, and FIG. 22B shows a state in which the shielding film is provided thereon.

As shown in FIG. 22A, the vertical CCD 102 is provided with a transfer channel 102a formed in the semiconductor substrate 101, as well as first vertical transfer electrodes 106 and second vertical transfer electrodes 109 formed thereon. The photo diode part 111 includes a photoelectric conversion part 111a, a readout part 111b, and a pixel separation part 111c. These are formed in the semiconductor substrate 101.

The photoelectric conversion part 111a generates a signal charge upon incidence of light thereon, and stores the charge. The readout part 111b is formed in a region between the photoelectric conversion part 111a and the vertical CCD 102 corresponding to the same, and reads out the charge stored in the photoelectric conversion part 111a. The charge read out is transferred to the transfer channel 102a. The pixel separation part 111c electrically separates the photoelectric conversion part 111a from another photoelectric conversion parts 111a adjacent to the same and the vertical CCD 102 not corresponding to the same.

The first vertical transfer electrode 106 and the second vertical transfer electrode 109 are formed so as to cover the transfer channel 102a, the readout part 111b, and the pixel separation part 111c. In FIG. 22A, the first vertical transfer electrode 106 and the second vertical transfer electrode 109 are shown by hatching.

Further, as shown in FIG. 22B, the shielding film 113 is formed so as to have an opening in which a top face of the photoelectric conversion part 111a is not covered and to shield the transfer channel 102a, the first vertical transfer electrode 106, and the second vertical transfer electrode 109. Only light passing through the opening of the shielding film 113 is incident on the photoelectric conversion part 111a. In the example shown in FIG. 22B, the contact hole 114 connects the shielding film 113 with the second vertical transfer electrode 109.

The following describes an operation of the solid-state imaging device shown in FIGS. 21 and 22. In the following description, FIGS. 21 and 22 are referred to as required. First, when an optical image is formed in the photo-detective region 101a of the semiconductor substrate 101, the photoelectric conversion part 111a in each photo diode part 111 carries out photoelectric conversion and stores signal charges corresponding to the intensity of light and the duration of incidence of light. In this state, a high-level voltage (10V to 15V) is applied to the second vertical transfer electrode 109 via the vertical bus line part 116 and the shielding film 113. This causes the signal charges stored in the photoelectric conversion part 111a of each photo diode part 111 to be transferred via the readout part 111b to the transfer channel 102a of the vertical CCD 102.

Next, in a similar manner to that described above, a middle-level (0V) and a low-level voltage (-5V to -10V) are applied alternately to the first vertical transfer electrodes 106 and the second vertical transfer electrodes 109 via the vertical bus line part 116 and the shielding film 113. This causes the signal charges to be transferred through the vertical CCDs 102 aligned vertically from one to another sequentially, thereby reaching the horizontal CCD 103.

Thereafter, a high-level voltage (2V to 5V) and a low-level voltage (0V) are applied alternately to the first horizontal transfer electrodes (not shown) and the second horizontal transfer electrodes of the horizontal CCD 103 via the horizontal bus line part 117. This causes the signal charges to be transferred from the horizontal CCD 103 to the output amplifier 103b.

The output amplifier 103b converts the signal charges into voltages, and outputs the voltage signal to outside. Thus, the signal charges stored in the photoelectric conversion parts 111a are transferred in a vertical direction by the vertical CCDs 102, then transferred in a horizontal direction by the horizontal CCD 103, and thereafter outputted to outside.

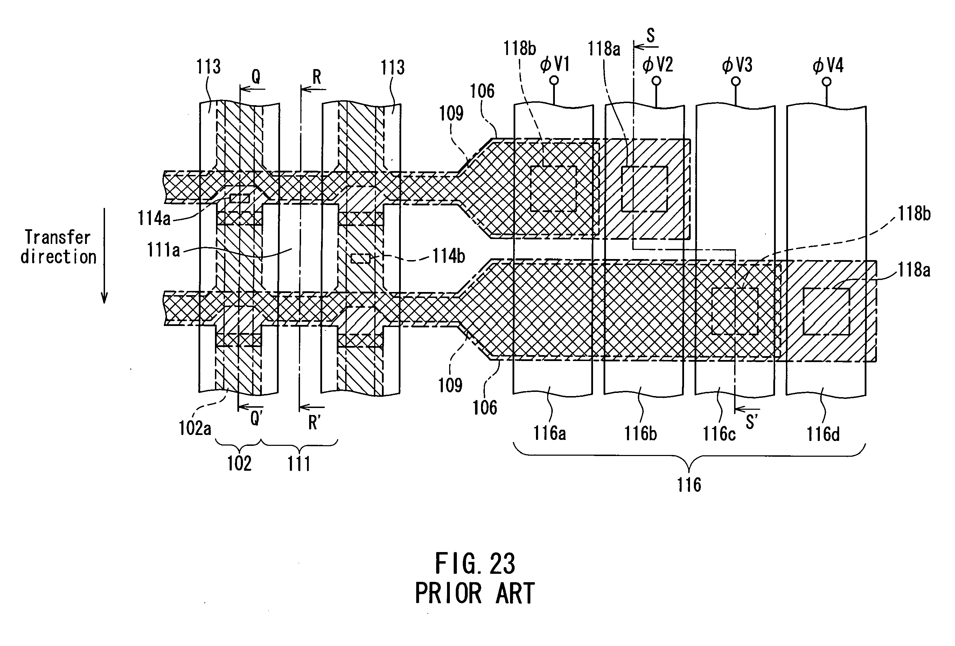

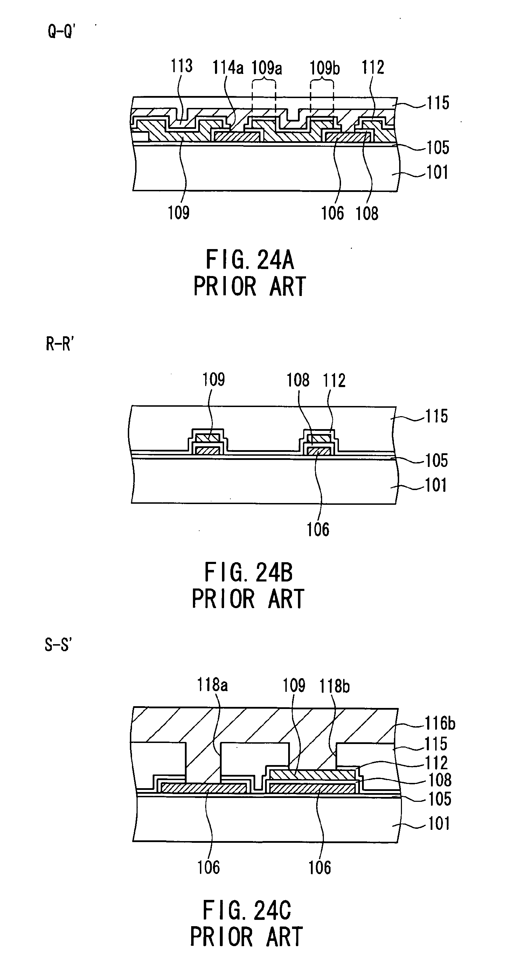

Next, a configuration of the transfer electrodes, the shielding films, and the bus line parts for the vertical CCDs and the horizontal CCD in the solid-state imaging device of the conventional example 1 shown in FIG. 21 is described specifically, with reference to FIGS. 23 to 26. First, a configuration regarding the vertical CCDs is described. FIG. 23 is a plan view illustrating the configuration of the vertical CCDs and the vertical bus line part of the solid-state imaging device shown in FIG. 21, and the view corresponds to a region X encircled by a broken line in FIG. 21. FIGS. 24A to 24C are cross-sectional views obtained by cutting the configuration shown in FIG. 23. FIG. 24A is a cross-sectional view taken along a cutting line Q- Q', FIG. 24B is a cross-sectional view taken along a cutting line R-R', and FIG. 24C is a cross-sectional view taken along a cutting line S-S'. It should be noted that in FIG. 24, only conductive members (excluding the semiconductor substrate) are hatched.

As shown in FIG. 23, the first vertical transfer electrodes 106 and the second vertical transfer electrodes 109 are formed to cross the plurality of transfer channels 102a formed in the vertical direction. The shielding films 113 are formed along the transfer channels 102a, i.e., so as to cross the first vertical transfer electrodes 106 and the second vertical transfer electrodes 109.

Further, each first vertical transfer electrode 106 is connected with the vertical bus line wire 116b or 116d via a contact hole 118a. Each second vertical transfer electrode 109 is connected with the vertical bus line wire 116a or 116c via a contact hole 118b. Each shielding film 113 is connected with the first vertical transfer electrode 106 via a contact hole 114a, and is connected with the second vertical transfer electrode 109 via a contact hole 114b.

As shown in FIGS. 24A to 24C, the plurality of first vertical transfer electrodes 106 are formed on a gate insulation film 105 at uniform intervals. Around each first vertical transfer electrode 106, a first interlayer insulation film 108 is formed. Further, as shown in FIGS. 24B and 24C, in regions where the transfer channels 102a are not formed, the second vertical transfer electrodes 109 are formed on the first vertical transfer electrodes 106 with the first interlayer insulation film 108 being interposed therebetween.

On the other hand, as shown in FIG. 24A, in the regions where the transfer channels 102a are formed, the second vertical transfer electrodes 109 are formed on a gate insulation film 105, between the first vertical transfer electrodes 106 neighboring to each other, so as to transfer charges. It should be noted that each second vertical transfer electrode 109 is formed so that edges 109a and 109b thereof overlap edges of the first vertical transfer electrode 106, respectively.

Further, as shown in FIG. 24A, a second interlayer insulation film 112 is formed to cover the gate insulation film 105, the first vertical transfer electrodes 106, and the second vertical transfer electrodes 109. Still further, the shielding films 113 are formed on the second interlayer insulation film 112. At positions where the shielding films 113 are connected with the first vertical transfer electrodes 106, contact holes 114a are formed, which perforate through the first interlayer insulation films 108 and the second interlayer insulation film 112. Still further, though not shown in FIG. 24, at positions where the shielding films 113 are connected with the second vertical transfer electrodes 109, contact holes 114b are formed, which perforate through the second interlayer insulation film 112 (see FIG. 23).

Still further, to cover the shielding film 113 (or in regions where the shielding films 113 are not formed, to cover the second interlayer insulation film 112), a third interlayer insulation film 115 is formed. The vertical bus line part 116 is formed on the third interlayer insulation film 115. As shown in FIG. 24C, at positions where the vertical bus line wire 116b (or 116d) is connected with the first vertical transfer electrodes 106, contact holes 118a are formed, which perforate through the first interlayer insulation films 108, the second interlayer insulation film 112, and the third interlayer insulation film 115. At positions where the vertical bus line wire 116c (or 116a) is connected with the second vertical transfer electrodes 109, contact holes 118b are formed, which perforate through the second interlayer insulation film 112, and the third interlayer insulation film 115.

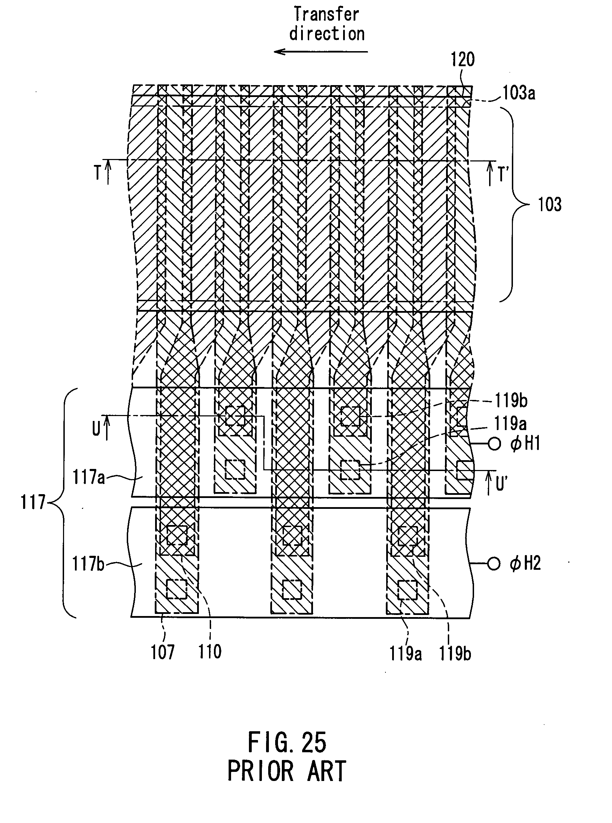

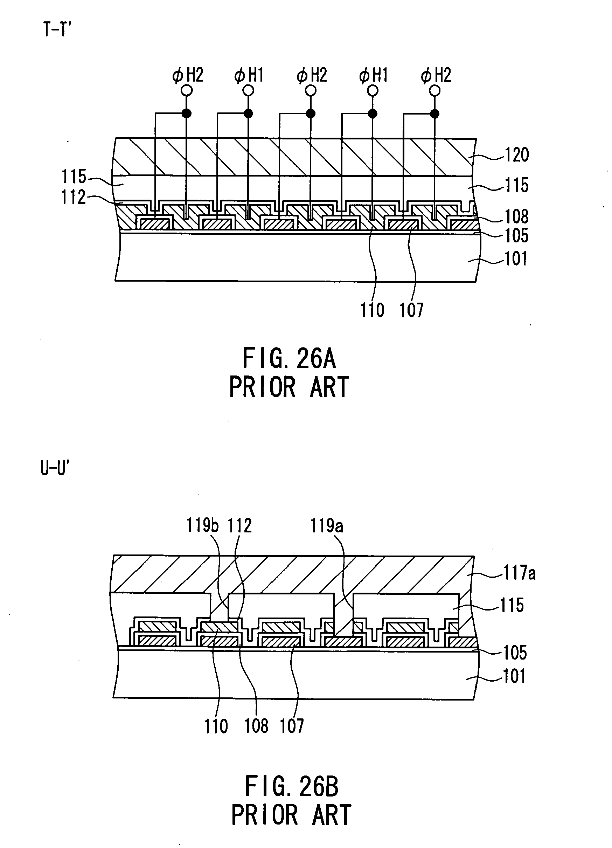

Next, the horizontal CCD is described. FIG. 25 is a plan view specifically illustrating a configuration of the horizontal transfer electrode and the horizontal bus line part of the solid-state imaging device shown in FIG. 21. FIGS. 26A and 26B are cross-sectional views obtained by cutting the configuration shown in FIG. 25. FIG. 26A is a cross-sectional view taken along a cutting line T-T', and FIG. 26B is a cross-sectional view taken along a cutting line U-U'. It should be noted that in FIG. 26, only conductive members (excluding the semiconductor substrate) are hatched.

As shown in FIG. 25, the horizontal CCD 103 includes a transfer channel 103a extended in the horizontal direction on the semiconductor substrate 101 (see FIG. 21), and first horizontal transfer electrodes 107 and second horizontal transfer electrodes 110 that are formed on the transfer channel 103a so as to cross the transfer channel 103a. The first horizontal transfer electrodes 107 are connected with the horizontal bus line wire 117a or 117b via contact holes 119a. The second horizontal transfer electrodes 110 are connected with the horizontal bus line wires 117a or 117b via contact holes 119b.

As shown in FIGS. 26A and 26B, like the case of the vertical CCDs (see FIGS. 24A to 24C), the first horizontal transfer electrodes 107 are formed on the gate insulation film 105, and around each of the same, the first interlayer insulation film 108 is formed. Still further, as shown in FIG. 26B, in regions where the transfer channel 103a of the horizontal CCD 103 is not formed, the second horizontal transfer electrodes 110 are formed on the first horizontal transfer electrodes 107 with the first interlayer insulation film 108 being interposed therebetween.

Further, like the case of the vertical CCDs, as shown in FIG. 26A, in a region where the transfer channel 103a is formed, the second horizontal transfer electrodes 110 are formed on the gate insulation film 105, between the first horizontal transfer electrodes 107 neighboring to each other, so as to transfer charges. In the region where the transfer channel 103a is formed, each second horizontal transfer electrode 110 is formed so that edges 110a and 110b thereof overlap edges of the corresponding first horizontal transfer electrode 107, respectively.

Still further, as shown in FIGS. 26A and 26B, the gate insulation film 105, the first horizontal transfer electrodes 107, and the second horizontal transfer electrodes 110 are covered with the second interlayer insulation film 112. The second interlayer insulation film 112 is covered with the third interlayer insulation film 115. Still further, as shown in FIG. 26B, horizontal bus line wires 117a and 117b are formed with a metal material on the third interlayer insulation film 115.

At positions where the horizontal bus line wire 117a (or 117b) and the first horizontal transfer electrodes 107 are connected with each other, contact holes 119a are formed, which perforate through the first interlayer insulation films 108, the second interlayer insulation film 112, and the third interlayer insulation film 115. Further, at positions where the horizontal bus line wire 117a (or 117b) and the second horizontal transfer electrode 109 are connected with each other, contact holes 119b are formed, which perforate through the second interlayer insulation film 112 and the third interlayer insulation film 115.

Further, as shown in FIG. 26A, in the region where the transfer channel 103a is formed, a shielding film 120 is formed on the third interlayer insulation film 115. The shielding film 120 is formed with the same material as that for the bus line wires 117a and 117b through the same process.

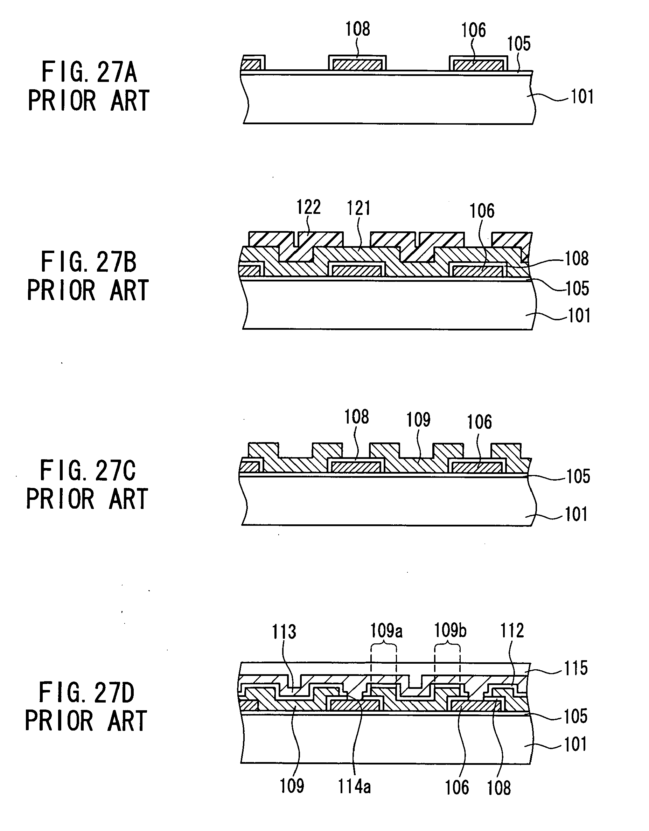

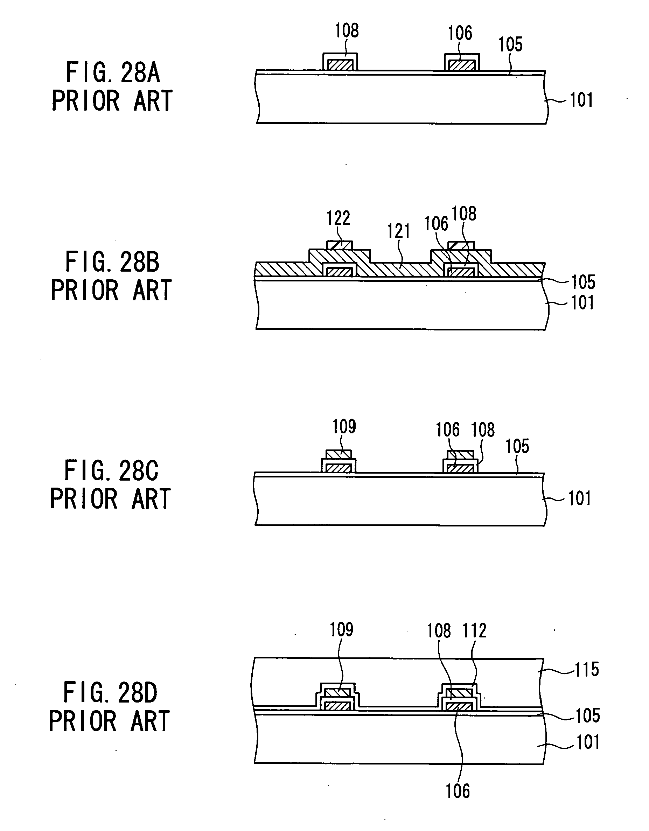

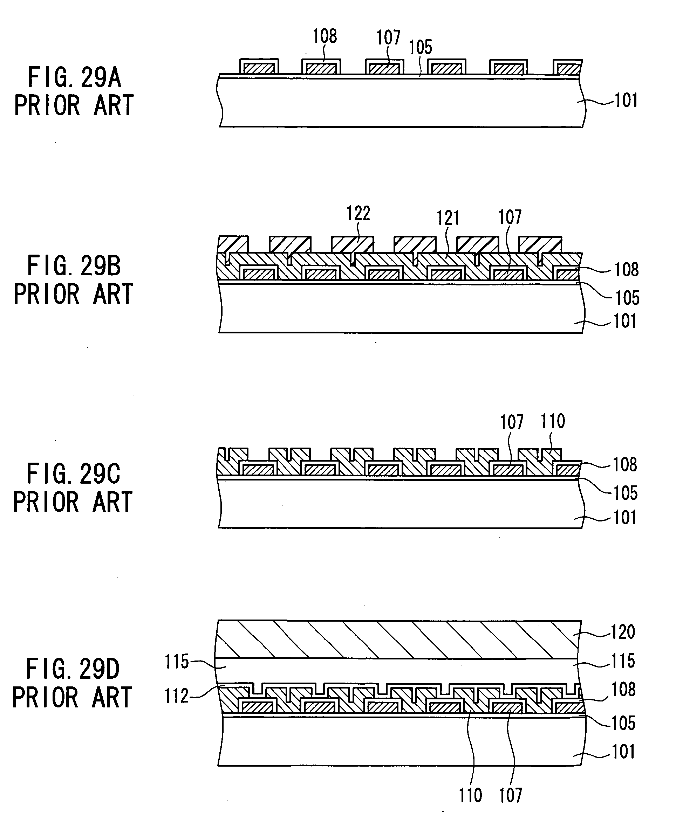

Next, a method for manufacturing the solid-state imaging device shown in FIGS. 21 to 26 of the conventional example 1 is described with reference to FIGS. 27 to 29. FIGS. 27 to 29 are cross-sectional views showing a method for manufacturing the solid-state imaging device shown in FIGS. 21 to 26. FIGS. 27A to 27D illustrate major steps in sequence, respectively. Likewise, FIGS. 28A to 28D and FIGS. 29A to 29D also illustrate the same major steps in sequence. FIGS. 27A to 27D correspond to the cross-sectional view of FIG. 24A, FIGS. 28A to 28D correspond to the cross-sectional view of FIG. 24B, and FIGS. 29A to 29D correspond to the cross-sectional view of FIG. 26A. It should be noted that in FIGS. 27 to 29, only conductive members (excluding the semiconductor substrate) and resist patterns are hatched.

First, as shown in FIGS. 27A, 28A, and 29A, an oxide film, a nitride film, or the like is formed as the gate insulation film 105 by thermal oxidation, low-pressure chemical vapor deposition (CVD), or the like on a surface of the semiconductor substrate 101 formed of a silicon substrate or the like. On the gate insulation film 105, a polysilicon film to be formed into the first vertical transfer electrodes 106 or the first horizontal transfer electrode 107 is formed by low-pressure CVD.

Subsequently, photolithography or reactive ion etching (RIE) are carried out for removing unnecessary portions of the polysilicon film according to a resist pattern. This forms the first vertical transfer electrodes 106 and the first horizontal transfer electrode 107 with predetermined spaces provided therebetween. Thereafter, the first interlayer insulation films 108 are formed by thermal oxidation around the first vertical transfer electrodes 106 and the first horizontal transfer electrode 107.

Next, as shown in FIGS. 27B, 28B, and 29B, a polysilicon film 121 is formed by low-pressure CVD on the first vertical transfer electrodes 106 and the first horizontal transfer electrode 107. The polysilicon film 121 is formed into the second vertical transfer electrode 109 and the second horizontal transfer electrode 110.

Next, as shown in FIGS. 27C, 28C, and 29C, a resist pattern 122 is formed by photolithography so as to cover only regions where the second vertical transfer electrodes 109 and the second horizontal transfer electrodes 110 are to be formed. Subsequently, RIE is carried out by using the resist pattern 122 as a mask, for removing unnecessary portions of the polysilicon film 121. By so doing, the second vertical transfer electrodes 109 and the second horizontal electrodes 110 are formed. After the end of RIE, the resist pattern 122 is removed.

Thereafter, as shown in FIGS. 27D, 28D, and 29D, the second interlayer insulation film 112, the third interlayer insulation film 115, the contact holes 114a, 114b, 119a, and 119b, and the shielding films 113 are formed. The shielding films 113 are formed with a metal material such as aluminum or tungsten, for example. Further, though not shown, the contact holes 118a and 118b, the vertical bus line wires 116a to 116d, and the horizontal bus line wires 117a and 117b are formed also. Still further, the shielding film 120 is formed. As a result, the solid-state imaging device as shown in FIGS. 21 to 26 is obtained.

In the solid-state imaging device having such a shunt wiring structure, as described above, the first vertical transfer electrodes 106 and the second vertical transfer electrodes 109 are connected electrically with the shielding films 113 via the contact holes 114a and 114b. To the first vertical transfer electrodes 106 and the second vertical transfer electrodes 109, a transfer pulse is fed from the shielding films 113 also. Besides, generally, a transfer electrode is formed of a polysilicon having a relatively high resistance (sheet resistance: approximately 50 Ω/ 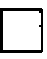 ), but the shielding film 113 is formed of aluminum (sheet resistance: 0.1 Ω/ 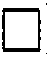 ) or tungsten (sheet resistance: 0.5 Ω/ 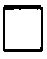 ).

Therefore, by using the solid-state imaging device having the shunt wiring structure, the waveform of the transfer pulse can be prevented very effectively from becoming dull, as compared with a solid-state imaging device not having a shunt wiring structure (in which a transfer pulse is applied only to transfer electrodes made of polysilicon). Thus, the high-speed driving at a speed ten times or more can be achieved.

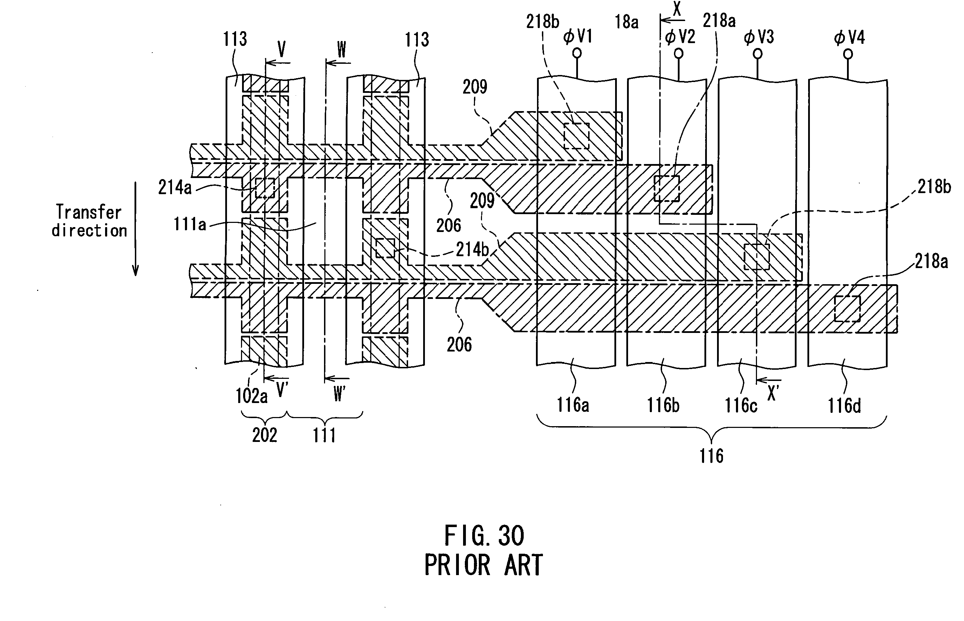

As a solid-state imaging device having a shunt wiring structure, a solid-state imaging device other than that shown in FIGS. 21 to 29 (conventional example 1) has been proposed (see, for instance, JP 5(1993)-267356A). Such another example of a solid-state imaging device having a shunt wiring structure (conventional example 2) is described below, with reference to FIGS. 30 to 36. First, a vertical CCD of the conventional example 2 is described.

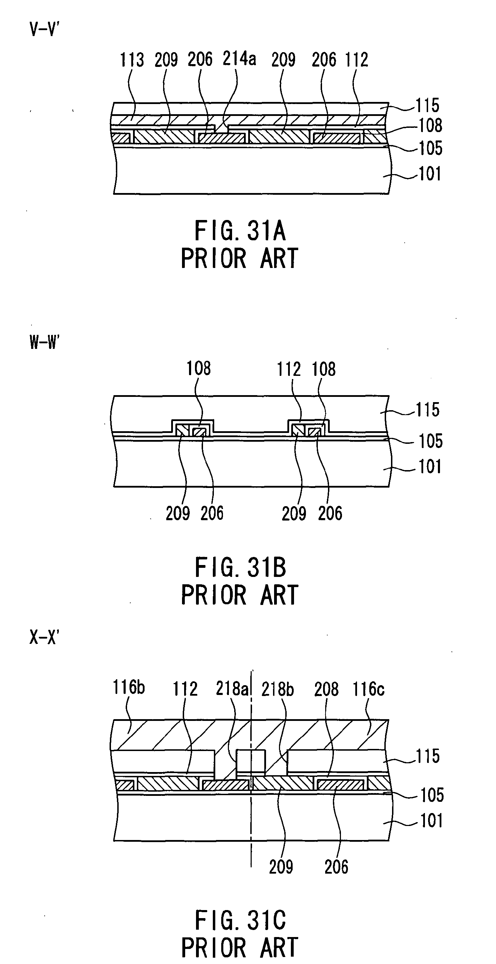

FIG. 30 is a plan view showing a configuration of vertical transfer electrodes, a vertical bus line part, and shielding films in the another example of a conventional solid-state imaging device having a shunt wiring structure. FIGS. 31A to 31C are cross-sectional views obtained by cutting the configuration shown in FIG. 30 along cutting lines. FIG. 31A is a cross-sectional view taken along a cutting line V-V', FIG. 31B is a cross-sectional view taken along a cutting line W-W', and FIG. 31C is a cross-sectional view taken along a cutting line X-X'. It should be noted that in FIG. 31 also, only conductive members (excluding the semiconductor substrate) are hatched. In FIGS. 30 to 31, the members configured in the same manner as those in the conventional example 1 are designated with the same reference numerals shown in FIGS. 23 to 24.

As shown in FIG. 30, the vertical CCDs 202 are provided with transfer channels 102a, first vertical transfer electrodes 206, and second vertical transfer electrodes 209. In the conventional example 2 also, like the conventional example 1, the first vertical transfer electrodes 206 and the second vertical transfer electrodes 209 are formed to cross the transfer channels 102a. Shielding films 113 are formed along the transfer channels 102a.

Further, like the conventional example 1, the first vertical transfer electrodes 206 are connected with the vertical bus line wires 116b or 116d via contact holes 218a. The second vertical transfer electrodes 209 are connected with the vertical bus line wires 116a or 116c via contact holes 218b. The shielding films 113 are connected with the first vertical transfer electrodes 206 via contact holes 214a, and are connected with the second vertical transfer electrodes 209 via contact holes 214b. As shown in FIGS. 31A to 31C, like the conventional example 1, the first vertical transfer electrodes 206 are formed at predetermined intervals on the gate insulation film 105. Around each first vertical transfer electrode 206, a first interlayer insulation film 108 is formed.

However, as shown in FIGS. 30 and 31, in the conventional example 2, unlike the conventional example 1, the second vertical transfer electrodes 109 are formed on the gate insulation film 105, between the first vertical transfer electrodes 106 neighboring to each other, even in regions where the transfer channels 102a are not formed. Further, the second vertical transfer electrodes 109 are formed so that, in the regions where the transfer channels 102a are formed, edges of the second vertical transfer electrodes 109 do not overlap the first vertical transfer electrodes 106.

It should be noted that as shown in FIGS. 31A to 31C, a second interlayer insulation film 112, shielding films 113, and a third interlayer insulation film 115 are formed in the conventional example 2 also, like the conventional example 1 (see FIG. 24). Further, the contact holes 214a perforate through the first interlayer insulation films 108 and the second interlayer insulation film 112. Though not shown in FIGS. 31A to 31C, the contact holes 214b perforate through the second interlayer insulation film 112. Further, as shown in FIG. 31C, the contact holes 218a perforate through the first interlayer insulation films 108, the second interlayer insulation film 112, and the third interlayer insulation film 115, while the contact holes 218b perforate through the second interlayer insulation film 112 and the third interlayer insulation film 115.

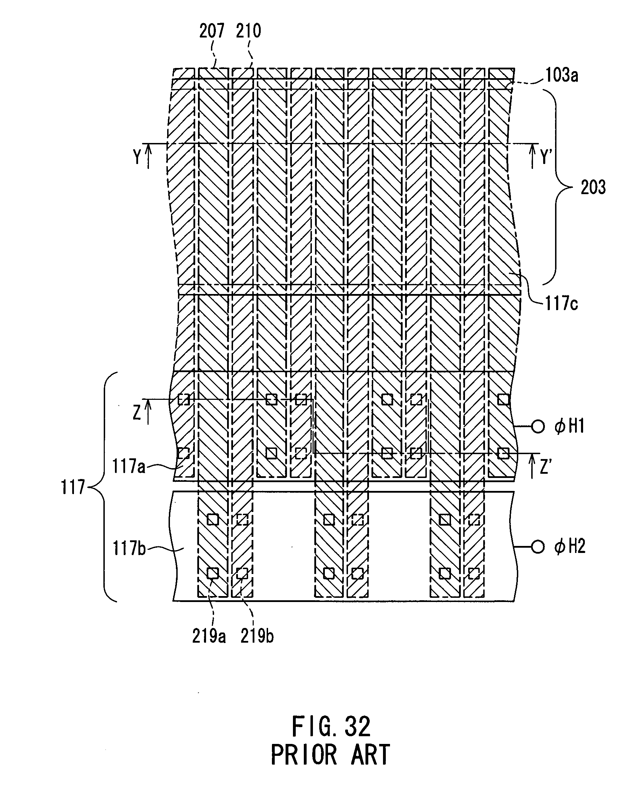

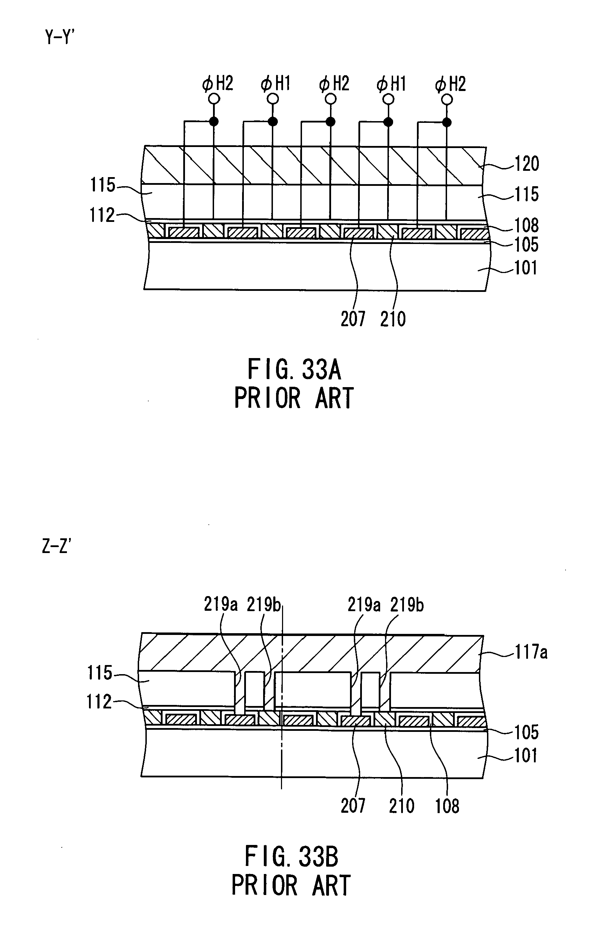

Next, the horizontal CCD of the conventional example 2 is described. FIG. 32 is a plan view illustrating a configuration of horizontal transfer electrodes and a horizontal bus line part in another example of a conventional solid-state imaging device having a shunt wiring structure. FIGS. 33A and 33B are cross-sectional views obtained by cutting the configuration shown in FIG. 32 along cutting lines. FIG. 33A is a cross-sectional view taken along a cutting line Y-Y', and FIG. 33B is a cross-sectional view taken along a cutting line Z-Z'. It should be noted that in FIG. 33 also, only conductive members (excluding the semiconductor substrate) are hatched. Still further, in FIGS. 32 and 33, the members configured in the same manner as those in the conventional example 1 are designated with the same reference numerals shown in FIGS. 25 and 26.

As shown in FIG. 32, the horizontal CCD 203 includes a transfer channel 103a, first horizontal transfer electrodes 207, and second horizontal transfer electrodes 210. In the conventional example 2 also, like in the conventional example 1, the first horizontal transfer electrodes 207 and the second horizontal transfer electrodes 210 are formed on the transfer channel 103a so as to cross the same.

Further, like in the conventional example 1, the first horizontal transfer electrodes 207 are connected with the horizontal bus line wire 117a or 117b via contact holes 219a. The second horizontal transfer electrodes 210 are connected with the horizontal bus line wire 117a or 117b via contact holes 219b. The first horizontal transfer electrodes 207 are formed at uniform intervals on the gate insulation film 105. Around each first horizontal transfer electrode 207, a first interlayer insulation film 108 is formed.

However, as shown in FIGS. 33A and 33B, in the conventional example 2, in the horizontal CCD 203 also, like in the case of the vertical CCDs 202, the second horizontal transfer electrodes 210 are formed on the gate insulation film 105, between the first vertical transfer electrodes 207 neighboring each other, in the entire region. Further, in a region where the transfer channel 103a is formed, the second horizontal transfer electrodes 210 are formed so that edges thereof do not overlap the first horizontal transfer electrodes 207. Therefore, in the region where the transfer channel 103a is not formed, the first horizontal transfer electrodes 207 and the second horizontal transfer electrodes 210 have smaller widths as compared with the case of the conventional example 1.

Further, like in the conventional example 1, second interlayer insulation films 112 and third interlayer insulation films 115 are formed. On the third interlayer insulation film 115, horizontal bus line wires 117a and 117b, and a shielding film 120 are formed. Still further, as shown in FIG. 33B, the contact holes 219a perforate through the first interlayer insulation films 108, the second interlayer insulation films 112, and the third interlayer insulation films 115. The contact holes 219b perforate through the second interlayer insulation film 112 and the third interlayer insulation film 115.

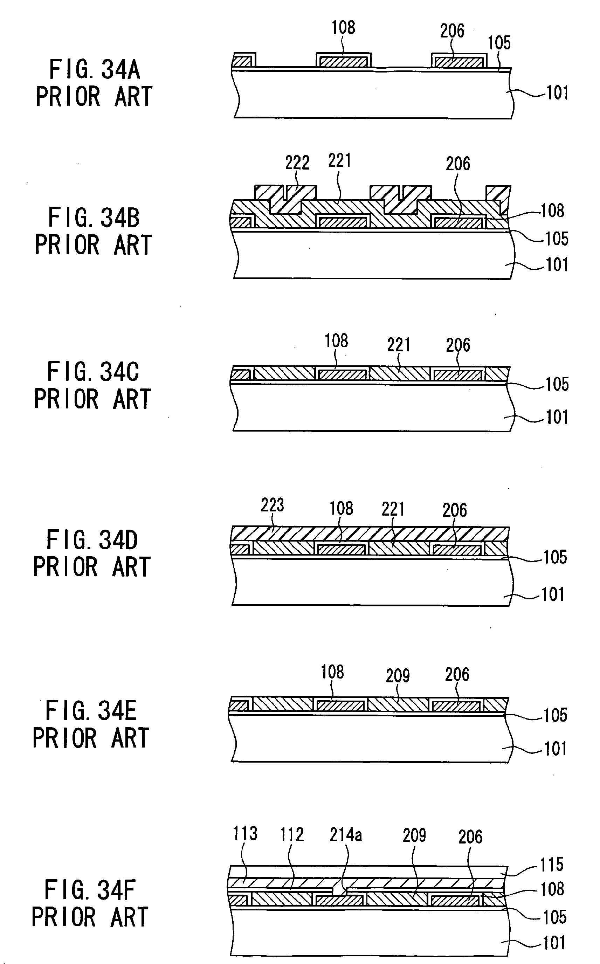

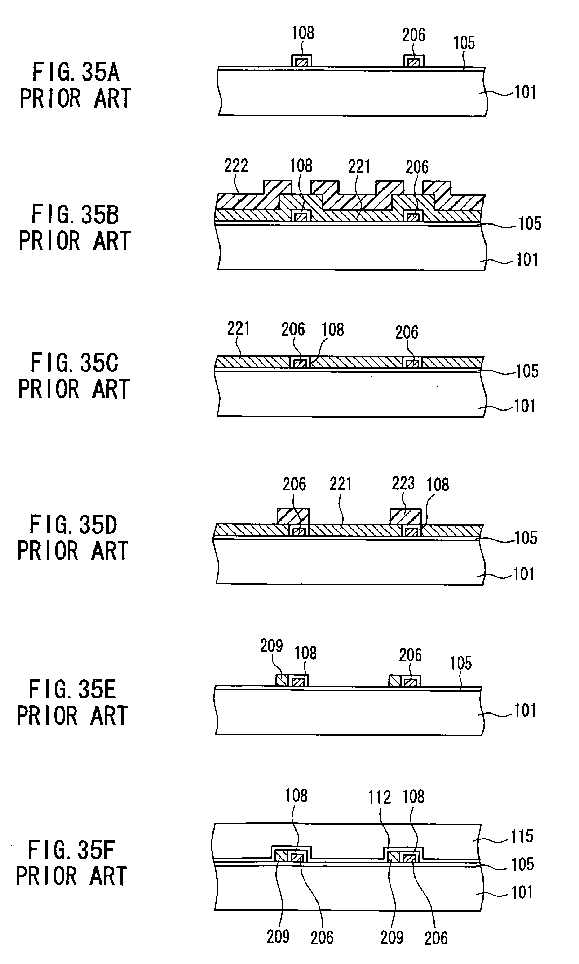

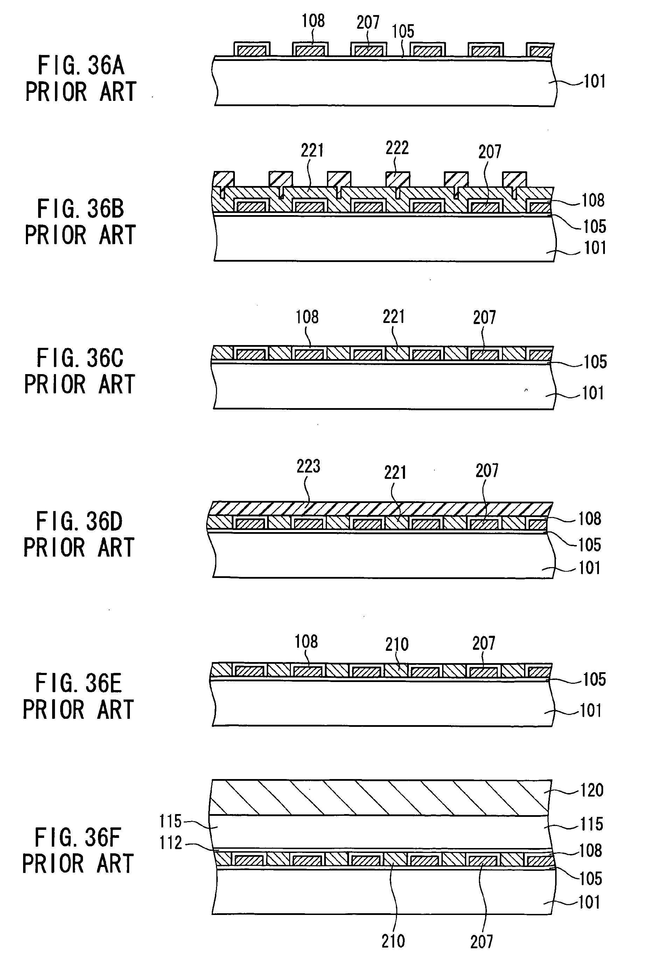

Next, a method for manufacturing the solid-state imaging device of the conventional example 2 shown in FIGS. 30 to 33 is described with reference to FIGS. 34 to 36. FIGS. 34 to 36 are cross-sectional views illustrating a method for manufacturing the solid-state imaging device shown in FIGS. 30 to 33. FIGS. 34A to 34F illustrate major steps in sequence, respectively. Likewise, FIGS. 35A to 35F and FIGS. 36A to 36F also illustrate the same major steps in sequence. FIGS. 34A to 34F correspond to the cross-sectional view of FIG. 31A, FIGS. 35A to 35F correspond to the cross-sectional view of FIG. 31B, and FIGS. 36A to 36F correspond to the cross-sectional view of FIG. 33A. It should be noted that in FIGS. 34 to 36, only conductive members (excluding the semiconductor substrate) and resist patterns are hatched.

First, as shown in FIGS. 34A, 35A, and 36A, the gate insulation film 105 and a polysilicon film are formed successively on a semiconductor substrate 101, and are subjected to photolithography and RIE. By so doing, the first vertical transfer electrodes 206 and the first horizontal transfer electrodes 207 are formed. Thereafter, the first interlayer insulation films 108 are formed. The steps shown in FIGS. 34A, 35A, and 36A illustrate steps identical to those shown in FIGS. 27A, 28A, and 29A, respectively.

Next, as shown in FIGS. 34B, 35B, and 36B, another polysilicon film 221 is formed by low-pressure CVD so as to cover a top face of the semiconductor substrate 101. Subsequently, a resist pattern 222 is formed by photolithography. The resist pattern 222 is formed so as not to overlap the first interlayer insulation film 108 in a thickness direction of the semiconductor substrate 101.

Next, the resist pattern 222 and the polysilicon film 221 are polished by chemical mechanical polishing (CMP) as shown in FIGS. 34C, 35C, and 36C. Here, a polishing rate for the polysilicon film 221 is set to be greater than the polishing rate for the first interlayer insulation films 108. Therefore, the first interlayer insulation films 108 are not polished, while only the polysilicon film 221 is polished, thereby being removed. By carrying out CMP, top faces of the first interlayer insulation films 108 and top faces of the remaining polysilicon films 221 are to form a continuous flat surface.

Next, as shown in FIGS. 34D, 35D, and 36D, a resist pattern 223 is formed by photolithography so that the remaining polysilicon films 221 are formed into the second vertical transfer electrodes 209 and the second horizontal transfer electrodes 210. Further, as shown in FIGS. 34E, 35E, and 36E, RIE is performed by using the resist pattern 223 as a mask. By so doing, the polysilicon film 221 is patterned, whereby the second vertical transfer electrodes 209 and the second horizontal transfer electrodes 210 are formed.

Thereafter, as shown in FIGS. 34F, 35F, and 36F, like in the conventional example 1, a second interlayer insulation film 112, a third interlayer insulation film 115, contact holes 214a, 214b, 219a, and 219b, and shielding films 113 are formed. Further, though not shown in the drawings, contact holes 118a and 118b, vertical bus line wires 116a to 116d, and horizontal bus line wires 117a and 117b are formed. Still further, a shielding film 120 is formed also. As a result, the solid-state imaging device of the conventional example 2 shown in FIGS. 30 to 33 is obtained. Unlike the conventional example 1, the conventional example 2 uses CMP, which is a significant difference from the conventional example 1.

The solid-state imaging devices of the conventional examples 1 and 2 described above have some problems. The following describes the problems.

In the solid-state imaging device of the conventional example 1, as shown in FIGS. 23 and 24, in the regions where the transfer channels 102a are formed, the second vertical transfer electrodes 109 are formed so that edges 109a and 109b thereof overlap edges of the first vertical transfer electrodes 106. Therefore, the contact holes 114a connecting the shielding films 113 with the first vertical transfer electrodes 106 have to be formed in regions, each of which is between the second vertical transfer electrodes 109 neighboring to each other, i.e., between the edge 109a of one of the same and the edge 109b of the other of the same.

However, a distance between the edges 109a of one and the edge 109b of the other of the two neighboring second vertical transfer electrodes 109 is small, and in the case where the pixel size is smaller than 3 µm square, for instance, the distance is less than 0.6 µm. In such a case, the contact hole 114a has to be formed to be smaller than 0.3 µm square, which is very difficult to form.

Further, since a distance between the edge 109a of one second vertical transfer electrode 109 and the edge 109b of another second vertical transfer electrode 109 neighboring thereto is small, a distance from the contact hole 114a to the edge 109a or the edge 109b of the second vertical transfer electrodes is small also. As a result, in some cases, the shielding film 113 and the second vertical transfer electrode 109 are brought into contact and short-circuited, due to variation of the hole size of the contact hole 114a and displacement occurring upon mask alignment in the process of forming the contact holes 114a and the second vertical transfer electrodes 109.

Still further, as described above, in the region where the transfer channels 102a of the vertical CCDs 102 are formed, the first vertical transfer electrodes 106 and the second vertical transfer electrodes 109 are formed so that edges of the both overlap each other, and hence, interlayer capacitances are generated therebetween. Further, since different pulses are applied to the first vertical transfer electrodes 106 and the second vertical transfer electrodes 109, respectively (see FIG. 23), an increase in the power consumption caused by the interlayer capacitances is a significant problem.

Likewise, in the region where the transfer channel 103a of the horizontal CCD is formed, the first horizontal transfer electrodes 107 and the second horizontal transfer electrodes 110, to which different pulses are applied respectively, are formed so that edges of the both overlap each other (see FIG. 26A), and hence, interlayer capacitances are generated therebetween. Therefore, the solid-state imaging device of the conventional example 1 has a problem of an increase in the power consumption caused by the interlayer capacitances, in the horizontal CCD 103 also.

On the other hand, in the solid-state imaging device of the conventional example 2, as shown in FIGS. 30 and 31, the second vertical transfer electrodes 209 do not overlap the first vertical transfer electrodes 206 in any region. Therefore, the hole size of the contact holes 214a that connect the shielding films 113 with the first vertical transfer electrodes 206 can be increased, as compared with the conventional example 1. Accordingly, even in the case where the pixel size is 3 µm square, for instance, contact holes 214a in a size of 0.3 µm square or larger can be formed. Further, as compared with the conventional example 1, the second vertical transfer electrodes 209 and the shielding films 113 are not likely short-circuited.

Still further, in the solid-state imaging device of the conventional example 2, since the first vertical transfer electrodes 206 and the second vertical transfer electrodes 209 are formed so as not to overlap each other, and so are the first horizontal transfer electrodes 207 and the second horizontal transfer electrodes 210, interlayer capacitances can be decreased, which results in a decrease in the power consumption, as compared with the conventional example 1.

However, since the transfer electrodes are not formed to overlap each other in the solid-state imaging device of the conventional example 2, the first vertical transfer electrodes 206 and the second vertical transfer electrodes 209 have widths (lengths in a direction of shorter edges thereof) smaller than those of the conventional example 1, in a region where the vertical bus line part 116 is formed. Likewise, in a region where the horizontal bus line part 117 is formed, the first and second horizontal transfer electrodes 207 and 210 have widths (lengths in a shorter edge direction thereof) smaller than those of the conventional example 1.

Therefore, it is necessary to reduce the hole size of the contact holes 218a and 218b connecting the vertical transfer electrodes and the vertical bus line part 116, as well as the hole size of the contact holes 219a and 219b connecting the horizontal transfer electrodes and the horizontal bus line part 117. This makes it difficult to form the holes and to provide contact of the horizontal transfer electrodes 207 and 210 with the bus line wires 117a and 117b.

Particularly in the case where the horizontal CCD 103 is of a two-phase drive type, four horizontal transfer electrodes 207 and 210 have to be formed per one pixel in a region where the horizontal bus line part 217 is formed. Therefore, to obtain denser pixels, widths (lengths in the shorter edge direction) of the horizontal transfer electrodes 207 and 210 are decreased significantly, which makes it difficult to form the contact holes 219a and 219b and to provide contact of the horizontal transfer electrodes 207 and 210 with the horizontal bus line wires 117a and 117b.

Further, in the case where the solid-state imaging device adopts the all-pixel-readout system, three or more vertical transfer electrodes 206 and 209 have to be formed per one pixel in a region where the vertical bus line part 116 is formed. Therefore, for the vertical CCDs 102 also, like for the horizontal CCD 103, widths (lengths in the shorter edge direction thereof) of the vertical transfer electrodes 206 and 209 have to be reduced significantly. This also makes it very difficult to form the contact holes 218a and 218b and to provide contact of the vertical transfer electrodes 206 and 209 with the vertical bus line wires 116a to 116d.

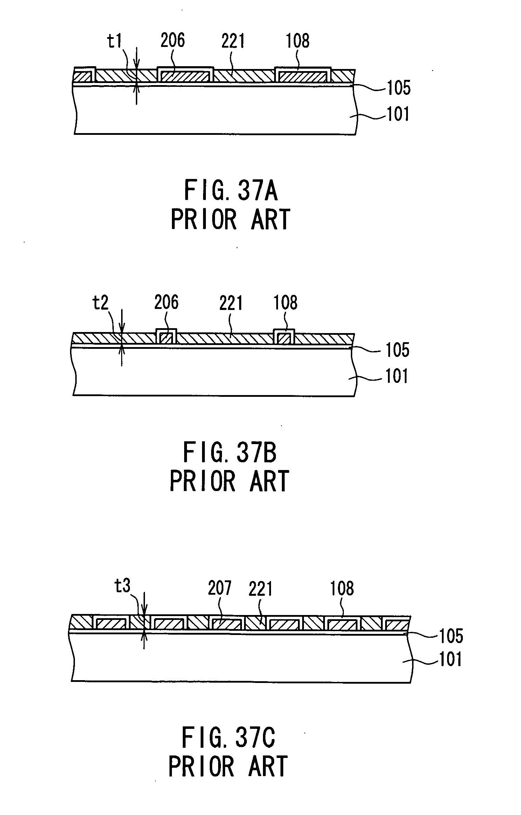

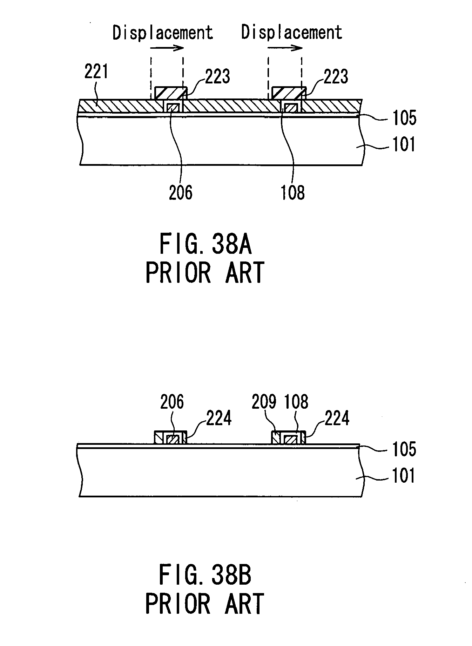

Still further, since CMP is used in the manufacture of the solid-state imaging device of the conventional example 2, a problem illustrated in FIGS. 37 and 38 occurs. FIGS. 37A to 37C are cross-sectional views illustrating one step in the method for manufacturing the solid-state imaging device shown in FIGS. 30 to 33, and FIGS. 37A to 37C show cross sections obtained at different positions in the same step. FIG. 37A corresponds to the cross-sectional view of FIG. 31C, FIG. 37B corresponds to the cross-sectional view of FIG. 31B, and FIG. 37C corresponds to the cross-sectional view of FIG. 33A.

As shown in FIGS. 37A to 37C, in the case where the manufacturing method of the conventional example 2 is used, the density of patterns of the first vertical transfer electrodes 206 and the first horizontal transfer electrodes 207 vary with regions. Therefore, the polysilicon films 221 obtained after polishing by CMP have different thicknesses (t1 to t3).

More specifically, the density of the first horizontal transfer electrodes 207 is higher than the density of the first vertical transfer electrodes 206. Therefore, in the region where the horizontal CCD is formed, for instance, if the polishing rate for the polysilicon film 222 is set to be greater than the polishing rate of the resist pattern 221 (see FIGS. 34 to 36), the resultant polysilicon films 221 have a thickness t3 substantially identical to a sum of the thickness of the first horizontal transfer electrodes 207 and the thickness of the first interlayer insulation films 108. On the other hand, the density of the first vertical transfer electrodes 206 is smaller than that of the first horizontal transfer electrodes 207. As a result, in the region where the vertical CCDs are formed, the thickness t1 or t2 of the remaining polysilicon films 221 is smaller than that of the polysilicon films 221 in the region where the horizontal CCD is formed.

Particularly in regions surrounding each photo diode part, as shown in FIG. 37B, the thickness t2 of the resultant polysilicon films 221 is further decreased since the density of the first vertical transfer electrodes 206 is smallest. Therefore, in the conventional example 2, there possibly occurs a problem that resistances of the second vertical transfer electrodes 209 and the second horizontal transfer electrodes 210 vary greatly, and consequently, the waveform dullness of the transfer pulse increases, thereby impairing the transfer efficiency. Further, in the case where the polysilicon films 221 have an excessively decreased thickness, there is a possibility that the second vertical transfer electrodes 209 and the second horizontal transfer electrodes 210 are broken.

FIGS. 38A and 38B are cross-sectional views illustrating a process for forming the second vertical transfer electrodes in the method for manufacturing the solid-state imaging device shown in FIGS. 30 to 33. FIGS. 38A and 38B show steps in sequence. In the solid-state imaging device manufacturing method of the conventional example 2, in regions surrounding each photo diode part, it is necessary to make one of the edges of each first interlayer insulation film fall on an edge of the resist pattern 223 corresponding thereto (see FIG. 35D).

However, as shown in FIG. 38A, in some cases, the resist pattern 223 is formed with displacement in the vertical direction of the pixels. If RIE is carried out in this state by using the resist pattern 223 as a mask, an isolate etching residue 224 of the polysilicon film 221 is formed on a side-wall of the first vertical transfer electrodes 206 in each region surrounding the photo diode part (in each region where a pixel separation part is formed) as shown in FIG. 38B. In this case, a capacitance is formed by the etching residue 224 and the first interlayer insulation film 108, which increases the power consumption. Further, as a result of the etching residue 224, the vertical transfer electrodes tend to be short-circuited, and black flows occur in images.

It is an object of the present invention provide a solid-state imaging device capable of solving the above-described problems, thereby providing an increase in the degree of freedom in layout design while reducing the power consumption due to interlayer capacitances, and to provide a method for manufacturing the same.

To achieve the above-described objects, a solid-state imaging device of the present invention includes a semiconductor substrate that includes a charge transfer part for transferring signal charges and a bus line part for supplying transfer pulses to the charge transfer part, wherein the charge transfer part includes: a transfer channel formed in the semiconductor substrate; a plurality of first transfer electrodes and a plurality of second transfer electrodes that are disposed on the transfer channel so as to cross the transfer channel; and shielding films formed on the first and second transfer electrodes so as to cover the transfer channel. The bus line part includes a plurality of bus line wires for supplying different transfer pulses, respectively, each of the bus line wires being connected with the first transfer electrodes or the second transfer electrodes. The plurality of first transfer electrodes and the plurality of second transfer electrodes are disposed so that the second transfer electrodes are positioned above the first transfer electrodes, at least in a region overlapping a place where bus line wires are formed in a thickness direction of the semiconductor substrate, whereas the first transfer electrodes and the second transfer electrodes are adjoined to each other in a region where the transfer channel is formed. The second transfer electrodes are formed so that a portion of each of the same on the region where the transfer channel is formed does not overlap, in the thickness direction of the semiconductor substrate, at least the first transfer electrode to which is applied a transfer pulse different from that applied to the second transfer electrode.

To achieve the above-described objects, a solid-state imaging device manufacturing method of the present inventionis for manufacturing a solid-state imaging device that includes a semiconductor substrate including a charge transfer part for transferring signal charges and a bus line part for supplying transfer pulses to the charge transfer part, wherein the charge transfer part includes a transfer channel formed in the semiconductor substrate as well as a plurality of first transfer electrodes and a plurality of second transfer electrodes that are disposed on the transfer channel so as to cross the transfer channel. The method comprises the steps of: (a) forming the transfer channel in the semiconductor substrate; (b) forming a first conductive film on the semiconductor substrate and patterning the first conductive film so as to form the plurality of first transfer electrodes; (c) forming first interlayer insulation films around the first transfer electrodes for providing insulation between the first transfer electrodes and the second transfer electrodes; (d) forming a second conductive film to cover the first transfer electrodes and the semiconductor substrate; (e) patterning the second conductive film so that the second conductive film remain on the first transfer electrodes at least in a region overlapping a place where bus line wires are formed in a thickness direction of the semiconductor substrate; and (f) forming a resist pattern so that in a region where the transfer channel is formed, the resist pattern having openings such that portions of the second conductive film overlapping the first interlayer insulation films in the thickness direction of the semiconductor substrate are not covered entirely or partially, and carrying out isotropic etching by using the resist pattern as a mask, so as to form the second transfer electrodes.

With the above-described characteristics, according to the solid-state imaging device and the manufacturing method of the same of the present invention, it is possible to provide the second vertical transfer electrodes with sufficient distances therebetween in the region where the transfer channel is formed. Therefore, it is possible to secure broader areas for forming contact holes that provide connection with the first transfer electrodes. Besides, at least in the region overlapping a place where the bus line wires are formed in the thickness direction of the semiconductor substrate, that is, in the region where the first transfer electrodes and the second transfer electrodes are connected with the bus line wires, the first transfer electrodes and the second transfer electrodes are arranged, with one being on the other. Thus, the widths thereof can be controlled so as not to be decreased. In view of these points, according to the solid-state imaging device and the manufacturing method thereof of the present invention, the degree of freedom in layout design can be increased.

Further, according to the solid-state imaging device and the manufacturing method thereof of the present invention, in the region where the transfer channel is formed, the second transfer electrodes are formed so as not to overlap at least the first transfer electrodes to which is applied a transfer pulse different from a transfer pulse applied to the second transfer electrodes. Therefore, it is possible to avoid increases in interlayer capacitances formed by the first transfer electrodes, the second transfer electrodes, and the insulation films providing insulation therebetween, and hence, it is possible to avoid an increase in the power consumption.
FIG. 1 is a plan view illustrating a configuration of vertical CCDs and a vertical bus line part of a solid-state imaging device according to Embodiment 1 of the present invention.
FIGS. 2A to 2C are cross-sectional views obtained by cutting the vertical CCDs and the vertical bus line part shown in FIG. 1. FIG. 2A is a cross-sectional view taken along a cutting line A-A', FIG. 2B is a cross-sectional view taken along a cutting line B-B', and FIG. 2C is a cross-sectional view taken along a cutting line C-C'.
FIG. 3 is a plan view illustrating a configuration of the horizontal CCD and a horizontal bus line part of the solid-state imaging device according to Embodiment 1 of the present invention.
FIGS. 4A and 4B are cross-sectional views obtained by cutting the horizontal CCD and the horizontal bus line part shown in FIG. 3. FIG. 4A is a cross-sectional view taken along a cutting line D-D', and FIG. 4B is a cross-sectional view taken along a cutting line E-E'.
FIGS. 5A to 5F are cross-sectional views illustrating a method for manufacturing the solid-state imaging device shown in FIGS. 1 to 4. FIGS. 5A to 5F show major steps thereof in sequence, respectively.
FIGS. 6A to 6F are cross-sectional views illustrating a method for manufacturing the solid-state imaging device shown in FIGS. 1 to 4. FIGS. 6A to 6F show major steps thereof in sequence, respectively.
FIGS. 7A to 7F are cross-sectional views illustrating a method for manufacturing the solid-state imaging device shown in FIGS. 1 to 4. FIGS. 7A to 7F show major steps thereof in sequence, respectively.
FIGS. 8A to 8F are cross-sectional views illustrating a method for manufacturing a solid-state imaging device according to Embodiment 2. FIGS. 8A to 8F show major steps thereof in sequence, respectively.
FIGS. 9A to 9F are cross-sectional views illustrating a method for manufacturing the solid-state imaging device according to Embodiment 2. FIGS. 9A to 9F show major steps thereof in sequence, respectively.
FIGS. 10A to 10F are cross-sectional views illustrating a method for manufacturing the solid-state imaging device according to Embodiment 2. FIGS. 10A to 10F show major steps thereof in sequence, respectively.
FIGS. 11A and 11B are cross-sectional views illustrating the step shown in FIG. 5D in Embodiment 1 in more detail. FIGS. 11A and 11B show the states prior to and after the isotropic etching, respectively.
FIGS. 12A and 12B are cross-sectional views illustrating the step shown in FIG. 8B in Embodiment 2 in more detail. FIGS. 12A and 12B show the states prior to and after the isotropic etching, respectively.
FIG. 13 is a plan view illustrating a configuration of vertical CCDs and a vertical bus line part of a solid-state imaging device of Embodiment 3 of the present invention.
FIGS. 14A to 14C are cross-sectional views obtained by cutting the vertical CCDs and the vertical bus line part shown in FIG. 13. FIG. 14A is a cross-sectional view taken along a cutting line F-F', FIG. 14B is a cross-sectional view taken along a cutting line G-G', and FIG. 14C is a cross-sectional view taken along a cutting line H-H'.
FIGS. 15A and 15B are cross-sectional views illustrating the cross-sectional configuration of the pixel separation parts in Embodiments 1 and 2. FIG. 15A is a cross-sectional view illustrating the cross-sectional configuration of the pixel separation part of the solid-state imaging device of Embodiment 1, and FIG. 15B is a cross-sectional view illustrating the cross-sectional configuration of the pixel separation part of the solid-state imaging device of Embodiment 2.
FIG. 16 is a plan view illustrating a configuration of the horizontal CCD and a horizontal bus line part of the solid-state imaging device according to Embodiment 3 of the present invention.
FIGS. 17A and 17B are cross-sectional views obtained by cutting the horizontal CCD and the horizontal bus line part shown in FIG. 16. FIG. 17A is a cross-sectional view taken along a cutting line I-I', and FIG. 17B is a cross-sectional view taken along a cutting line J-J'.
FIGS. 18A to 18F are cross-sectional views illustrating a method for manufacturing the solid-state imaging device shown in FIGS. 13, 14, 16, and 17. FIGS. 18A to 18F illustrate major steps thereof in sequence, respectively.
FIGS. 19A to 19F are cross-sectional views illustrating a method for manufacturing the solid-state imaging device shown in FIGS. 13, 14, 16, and 17. FIGS. 19A to 19F illustrate major steps thereof in sequence, respectively.
FIGS. 20A to 20F are cross-sectional views illustrating a method for manufacturing the solid-state imaging device shown in FIGS. 13, 14, 16, and 17. FIGS. 20A to 20F illustrate major steps thereof in sequence, respectively.
FIG. 21 is a schematic view illustrating the overall configuration of a solid-state imaging device having a shunt wiring structure of the prior art.
FIGS. 22A and 22B are enlarged views illustrating the configuration of the pixel of the solid-state imaging device shown in FIG. 21. FIG. 22A shows a configuration below the shielding film, and FIG. 22B shows a state in which the shielding film is provided thereon.
FIG. 23 is a plan view illustrating a configuration of the vertical CCDs and the vertical bus line part of the solid-state imaging device shown in FIG. 21, and the view corresponds to a region X encircled by a broken line in FIG. 21.
FIGS. 24A to 24C are cross-sectional views obtained by cutting the configuration shown in FIG. 23. FIG. 24A is a cross-sectional view taken along a cutting line Q-Q', FIG. 24B is a cross-sectional view taken along a cutting line R-R', and FIG. 24C is a cross-sectional view taken along a cutting line S-S'.
FIG. 25 is a plan view specifically illustrating a configuration of the horizontal transfer electrode and the horizontal bus line part of the solid-state imaging device shown in FIG. 21.
FIGS. 26A and 26B are cross-sectional views obtained by cutting the configuration shown in FIG. 25. FIG. 26A is a cross-sectional view taken along a cutting line T-T', and FIG. 26B is a cross-sectional view taken along a cutting line U-U'.
FIGS. 27A to 27D are cross-sectional views showing a method for manufacturing the solid-state imaging device shown in FIGS. 21 to 26. FIGS. 27A to 27D illustrate major steps thereof in sequence, respectively.
FIGS. 28A to 28D are cross-sectional views showing the method for manufacturing the solid-state imaging device shown in FIGS. 21 to 26. FIGS. 28A to 28D illustrate major steps thereof in sequence, respectively
FIGS. 29A to 29D are cross-sectional views showing the method for manufacturing the solid-state imaging device shown in FIGS. 21 to 26. FIGS. 29A to 29D illustrate major steps thereof in sequence, respectively.
FIG. 30 is a plan view showing a configuration of vertical transfer electrodes, a vertical bus line part, and shielding films in another example of a conventional solid-state imaging device having a shunt wiring structure.
FIGS. 31A to 31C are cross-sectional views obtained by cutting the configuration shown in FIG. 30 along cutting lines. FIG. 31A is a cross-sectional view taken along a cutting line V-V', FIG. 31B is a cross-sectional view taken along a cutting line W-W', and FIG. 31C is a cross-sectional view taken along a cutting line X-X'.
FIG. 32 is a plan view illustrating a configuration of horizontal transfer electrodes and a horizontal bus line part in another example of a conventional solid-state imaging device having a shunt wiring structure.
FIGS. 33A and 33B are cross-sectional views obtained by cutting the configuration shown in FIG. 32 along cutting lines. FIG. 33A is a cross-sectional view taken along a cutting line Y-Y', and FIG. 33B is a cross-sectional view taken along a cutting line Z-Z'.
FIGS. 34A to 34F are cross-sectional views illustrating a method for manufacturing the solid-state imaging device shown in FIGS. 30 to 33. FIGS. 34A to 34F illustrate major steps thereof in sequence, respectively
FIGS. 35A to 35F are cross-sectional views illustrating a method for manufacturing the solid-state imaging device shown in FIGS. 30 to 33. FIGS. 35A to 35F illustrate major steps thereof in sequence, respectively.
FIGS. 36A to 36F are cross-sectional views illustrating a method for manufacturing the solid-state imaging device shown in FIGS. 30 to 33. FIGS. 36A to 36F illustrate major steps in sequence, respectively.
FIGS. 37A to 37C are cross-sectional views illustrating one step in the method for manufacturing the solid-state imaging device shown in FIGS. 30 to 33. FIGS. 37A to 37C show cross sections obtained at different positions in the same step.
FIGS. 38A and 38B are cross-sectional views illustrating a process for forming the second vertical transfer electrodes in the method for manufacturing the solid-state imaging device shown in FIGS. 30 to 33. FIGS. 38A and 38B show steps in sequence.

To achieve the above-described objects, a solid-state imaging device of the present invention includes a semiconductor substrate that includes a charge transfer part for transferring signal charges, and a bus line part for supplying transfer pulses to the charge transfer part. The charge transfer part includes: a transfer channel formed in the semiconductor substrate; a plurality of first transfer electrodes and a plurality of second transfer electrodes that are disposed on the transfer channel so as to cross the transfer channel; and shielding films formed on the first and second transfer electrodes so as to cover the transfer channel. The bus line part includes a plurality of bus line wires for supplying different transfer pulses, respectively, each of the bus line wires being connected with the first transfer electrodes or the second transfer electrodes. The plurality of first transfer electrodes and the plurality of second transfer electrodes are disposed so that the second transfer electrodes are positioned above the first transfer electrodes, at least in a region overlapping a place where bus line wires are formed in a thickness direction of the semiconductor substrate, whereas the first transfer electrodes and the second transfer electrodes are adjoined to each other in a region where the transfer channel is formed. The second transfer electrodes are formed so that a portion of each of the same on the region where the transfer channel is formed does not overlap, in the thickness direction of the semiconductor substrate, at least the first transfer electrode to which a transfer pulse different from that applied to the second transfer electrode is applied.

Further, the above-described solid-state imaging device of the present invention may be configured so that a part of the charge transfer part constitutes a vertical charge transfer part for transferring the signal charges in a vertical direction. A plurality of the transfer channels of the vertical charge transfer part are disposed so as to extend in the vertical direction. The first transfer electrodes and the second transfer electrodes of the vertical charge transfer part are disposed so as to cross the plurality of the transfer channels of the vertical charge transfer part, and the second transfer electrodes of the vertical charge transfer part are formed so that portions of the same in regions where the transfer channels of the vertical charge transfer part are formed do not overlap the first transfer electrodes of the vertical charge transfer part in the thickness direction of the semiconductor substrate.

In the foregoing configuration, the shielding films of the vertical charge transfer part may be formed to cover the plurality of transfer channels of the vertical charge transfer part, respectively, and the shielding films may be connected via contact holes with either the first transfer electrodes or the second transfer electrodes of the vertical charge transfer part, in the regions where the transfer channels are formed.

The foregoing configuration makes it possible to secure broader areas for forming contact holes that connect the first transfer electrodes with the shielding films without narrowing portions of the first transfer electrodes and the second transfer electrodes to be connected with the bus line part in the vertical charge transfer part (vertical CCDs). Therefore, the degree of freedom is increased in the design of the contact holes for connecting the first transfer electrodes with the shielding films and the contact holes for connecting the first and second transfer electrodes with the bus line part. Further, the foregoing configuration also makes it possible to prevent the contact holes for connecting the first transfer electrodes with the shielding films from being brought into contact with edges of the second transfer electrodes and causing short-circuiting. Still further, interlayer capacitances in the vertical charge transfer part can be decreased.

Further, the above-described solid-state imaging device of the present invention may be configured so that the semiconductor substrate further includes a plurality of photoelectric conversion parts for converting incident light into signal charges, and the photoelectric conversion parts are arranged in vertical and horizontal directions in a matrix form on the semiconductor substrate. In this case, it is preferable that the semiconductor substrate further includes pixel separation parts for separating the photoelectric conversion parts neighboring to each other in the vertical direction, and the second transfer electrodes of the vertical charge transfer part are formed so that portions thereof in regions where the pixel separation parts are formed also do not overlap the first transfer electrodes of the vertical transfer part in the thickness direction of the semiconductor substrate. This configuration allows steps around the photoelectric conversion parts to be made smaller, which then increases an angle of incidence of light incident on the photoelectric conversion parts. Therefore, pixels with high sensitivity can be obtained.

Further, the above-described solid-state imaging device of the present invention may be configured so that a part of the charge transfer part constitutes a horizontal charge transfer part for transferring the signal charges in the horizontal direction. The transfer channel of the horizontal charge transfer part is disposed to extend in the horizontal direction, the first transfer electrodes and the second transfer electrodes of the horizontal charge transfer part are disposed to cross the transfer channel of the horizontal charge transfer part, and the second transfer electrodes of the horizontal charge transfer part are formed so that a portion of each of the same in a region where the transfer channel of the horizontal charge transfer part is formed does not overlap, in the thickness direction of the semiconductor substrate, at least the first transfer electrode of the horizontal transfer part to which is applied a transfer pulse different from that applied to the second transfer electrode.

The foregoing configuration is ready for densification of pixels, while making it possible to avoid, in the horizontal charge transfer part (horizontal CCD), decreases of widths of the portions of the first and second transfer electrodes connected with the bus line part. In other words, even if the pitches between the first and second transfer electrodes are decreased, the degree of freedom in the design of the contact holes for connecting the first and second transfer electrodes with the bus line part can be ensured. Further, interlayer capacitances in the horizontal charge transfer part can be reduced.

Further, in the foregoing configuration, it is preferable that the second transfer electrodes of the horizontal charge transfer part are formed so that a portion of each of the same in the region where the transfer channel of the horizontal charge transfer part is formed does not overlap, in the thickness direction of the semiconductor substrate, the first transfer electrode of the horizontal charge transfer part to which is applied a transfer pulse different from that applied to the second transfer electrode, and the first transfer electrode of the horizontal charge transfer part to which is applied the same transfer pulse as that applied to the second transfer electrode. In this case, the interlayer capacitances in the horizontal charge transfer part can be reduced further. Besides, since the steps in the horizontal charge transfer part due to the second transfer electrodes can be made smaller, wiring capacitances can be reduced in the case where conductive shielding films are formed thereon.

A solid-state imaging device manufacturing method of the present invention is a method for manufacturing a solid-state imaging device that includes a semiconductor substrate including a charge transfer part for transferring signal charges and a bus line part for supplying transfer pulses to the charge transfer part, wherein the charge transfer part includes a transfer channel formed in the semiconductor substrate as well as a plurality of first transfer electrodes and a plurality of second transfer electrodes that are disposed on the transfer channel so as to cross the transfer channel. The method includes the steps of: (a) forming the transfer channel in the semiconductor substrate; (b) forming a first conductive film on the semiconductor substrate and patterning the first conductive film so as to form the plurality of first transfer electrodes; (c) forming first interlayer insulation films around the first transfer electrodes for providing insulation between the first transfer electrodes and the second transfer electrodes; (d) forming a second conductive film to cover the first transfer electrodes and the semiconductor substrate; (e) patterning the second conductive film so that the second conductive film remain on the first transfer electrodes at least in a region overlapping a place where bus line wires are formed in a thickness direction of the semiconductor substrate; and (f) forming a resist pattern so that in a region where the transfer channel is formed, the resist pattern has openings such that portions of the second conductive film overlapping the first interlayer insulation films in the thickness direction of the semiconductor substrate are not covered entirely or partially, and carrying out isotropic etching by using the resist pattern as a mask, so as to form the second transfer electrodes.

The above-described solid-state imaging device manufacturing method of the present invention may be modified so that the step (e) is carried out after the step (f) is carried out, so as to form the second transfer electrodes. With this, the flatness of the top faces of the second transfer electrode can be achieved easily, whereby a configuration with smaller steps can be obtained.

The above-described solid-state imaging device manufacturing method of the present invention may be modified so as to include the further steps of: forming a plurality of photoelectric conversion parts in the semiconductor substrate, the photoelectric conversion parts being to convert incident light into signal charges, and being arranged in vertical and horizontal directions in a matrix form; and forming pixel separation parts in the semiconductor substrate, the pixel separation parts separating the photoelectric conversion parts neighboring to each other in the vertical direction. In the step (f), the resist pattern is formed so that in regions where the pixel separation parts are formed also, the resist pattern has openings such that portions of the second conductive film overlapping the first interlayer insulation films in the thickness direction of the semiconductor substrate are not covered, and the isotropic etching is carried out with use of the resist pattern. Since this allows steps around the photoelectric conversion parts to be made smaller in the solid-state imaging device thus obtained, this broadens an angle of incidence of light incident on the photoelectric conversion parts. Therefore, pixels with high sensitivity can be obtained.

Further, the above-described solid-state imaging device manufacturing method of the present invention may be modified so as to include the further steps of: forming a second interlayer insulation film to cover the first transfer electrodes and the second transfer electrodes; forming a contact hole in the second interlayer insulation film in the region where the transfer channel is formed, so that in a bottom of the contact hole either the first transfer electrode or the second transfer electrode is exposed; filling the contact hole with a conductive material, and further forming a film of the conductive material over the second interlayer insulation film; and patterning the film of the conductive material so as to form a shielding film to cover the transfer channel.

### Embodiment 1

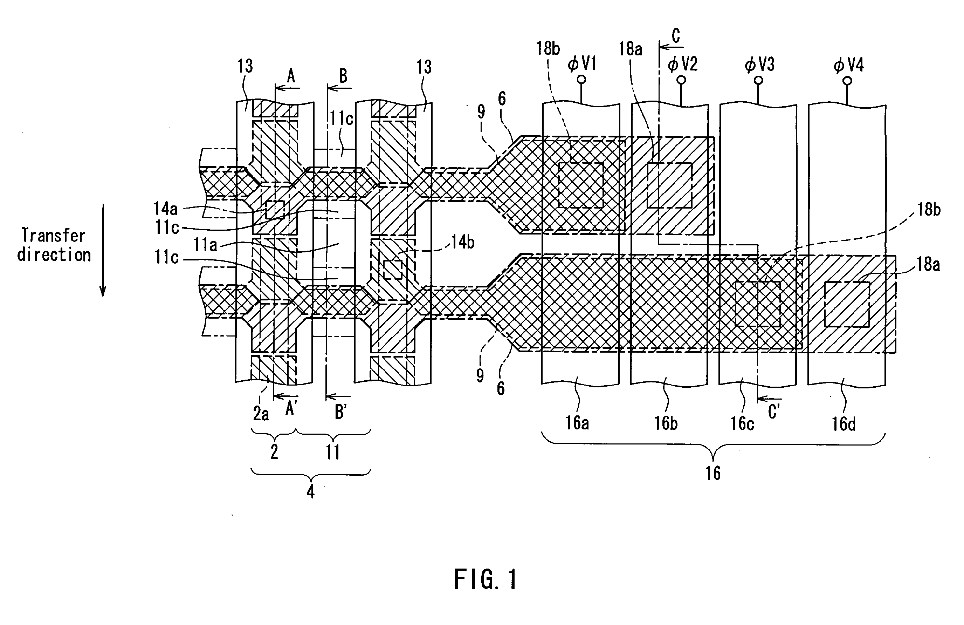

The following describes a solid-state imaging device and a solid-state imaging device manufacturing method according to Embodiment 1 of the present invention, while referring to FIGS. 1 to 7. First, a configuration of the solid-state imaging device according to Embodiment 1 is described with reference to FIGS. 1 to 4.

The solid-state imaging device according to Embodiment 1 also, like the solid-state imaging devices of the conventional examples 1 and 2 described in the "Description of Related Art" section, is formed by arranging a plurality of pixels in a matrix in a photo-detective region of a semiconductor substrate. Each pixel includes a vertical charge transfer part (hereinafter referred to as "vertical CCD") and a photo diode part. Further, a horizontal charge transfer part (hereinafter referred to as "horizontal CCD"), a vertical bus line part, and a horizontal bus line part are formed in the semiconductor substrate.

Further, also in Embodiment 1, the solid-state imaging device is an interline transfer CCD that adopts the interline transfer technology. However, it should be noted that the transfer mechanism is not limited particularly in the present invention, and the solid-state imaging device may be a full frame CCD, or a frame transfer CCD. Besides, in the case where the solid-state imaging device is a full frame CCD or a frame transfer CCD, a vertical charge transfer part functions as a photoelectric conversion part that converts incident light to signal charges.

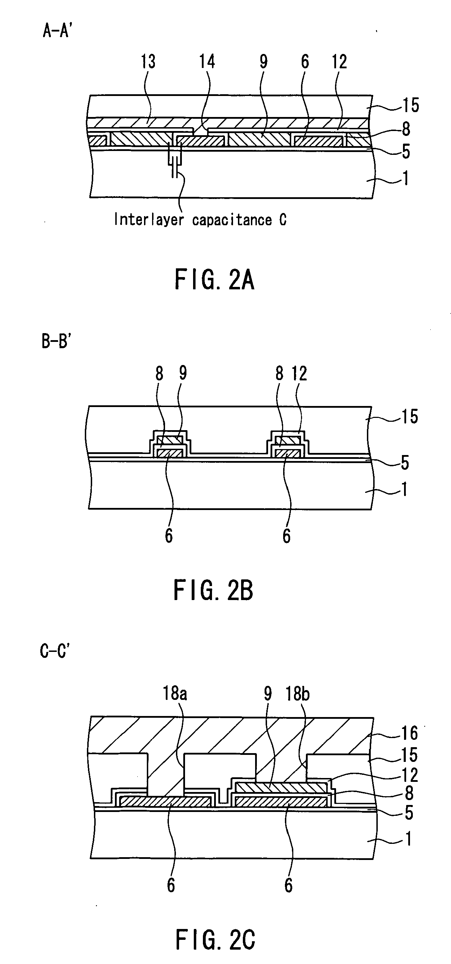

The configuration of the solid-state imaging device in Embodiment 1 is described, regarding each part thereof. First, a vertical CCD in Embodiment 1 is described. FIG. 1 is a plan view illustrating a configuration of vertical CCDs and a vertical bus line part of the solid-state imaging device in Embodiment 1 of the present invention. FIGS. 2A to 2C are cross-sectional views obtained by cutting the vertical CCDs and the vertical bus line part shown in FIG. 1. FIG. 2A is a cross-sectional view taken along a cutting line A-A', FIG. 2B is a cross-sectional view taken along a cutting line B-B', and FIG. 2C is a cross-sectional view taken along a cutting line C-C'. It should be noted that in FIGS. 2A to 2C, only conductive members (excluding the semiconductor substrate) are hatched.

As shown in FIG. 1, in Embodiment 1 also, like in the conventional examples 1 and 2 described in the "Description of Related Art" section, each of the vertical CCDs 2 is provided with a transfer channel 2a extended in a vertical direction, and first and second transfer electrodes 6 and 9 formed so as to cross the transfer channel 2a. The transfer channels 2a are formed in the semiconductor substrate 1 (see FIG. 2). It should be noted that hereinafter the first transfer electrodes 6 of the vertical CCDs 2 are referred to as "first vertical transfer electrodes" 6, while the second transfer electrodes 9 of the vertical CCDs 2 are referred to as "second vertical transfer electrodes" 9.

Further, as shown in FIGS. 2A to 2C, the first vertical transfer electrodes 6 are formed on a gate insulation film 5 of the semiconductor substrate 1. The first vertical transfer electrodes 6 are insulated from the second vertical transfer electrodes 9 by first interlayer insulation films 8. In regions where the transfer channels 2a are formed, the first vertical transfer electrodes 6 and the second vertical transfer electrodes 9 are disposed so as to be adjoined to each other.

Still further, in Embodiment 1 also, a photo diode part 11 includes a photoelectric conversion part 11a that stores signal charges according to an intensity of incident light and a incidence time of light, a readout part that reads out signal charges (not shown in FIG. 1 (see FIG. 22A)), and a pixel separation part 11c. On the first vertical transfer electrodes 6 and the second vertical transfer electrodes 9, shielding films 13 are formed in a stripe form, so as to cover the plurality of transfer channels 2a, respectively. Further, as shown in FIGS. 1 and 2A, the shielding films 13 are connected with the first vertical transfer electrodes 6 via contact holes 14a, and are connected with the second vertical transfer electrodes 9 via contact holes 14b.

Still further, in Embodiment 1, the vertical bus line part 16 includes vertical bus line wires 16a to 16d, and different transfer pulses ΦV1 to ΦV4 are fed from outside to the vertical bus line wires 16a to 16d, respectively. Still further, the first vertical transfer electrodes 6 are connected with the vertical bus line wires 16b and 16d via contact holes 18a. The second vertical transfer electrodes 9 are connected with the vertical bus line wires 16a and16c via contact holes 18b. This configuration allows different transfer pulses to be applied to the first vertical transfer electrodes 6 and the second vertical transfer electrodes 9, respectively.

It should be noted that the configuration of the vertical CCDs 2 and the vertical bus line part 16 of the solid-state imaging device according to Embodiment 1 differs from the conventional examples 1 and 2 described in the "Description of Related Art" section. In Embodiment 1, as shown in FIGS. 1, 2B and 2C, in regions where the transfer channels 2a are not formed, the plurality of first vertical transfer electrodes 6 and the plurality of second vertical transfer electrodes 9 are arranged so that the latter are positioned above the former.

Further, in Embodiment 1, as shown in FIGS. 1 and 2A, the second vertical transfer electrodes 9 are formed so that portions thereof in the regions where the transfer channels 2a are formed do not overlap the first vertical transfer electrodes 6 in a direction of thickness of the semiconductor substrate 1 (hereinafter referred to as semiconductor substrate 1 thickness direction), i.e., so that any edge portion of each second vertical transfer electrode 9 should not protrude to above the first vertical transfer electrodes 6.

Thus, in Embodiment 1, in the regions where the transfer channels 2a are formed, the second vertical transfer electrodes 9 are not present above the first vertical transfer electrodes 6, and accordingly, an area for forming each contact hole 14a is larger, as compared with the conventional example 1. For instance, in the case where the pixel size is 3 µm square, the first vertical transfer electrodes 6 of the vertical CCDs 2 are allowed to have a length in the transfer direction of 1 µm surely. Consequently, the contact holes 14a can be formed easily in a size of 0.3 µm square or larger each.

Still further, in regions where the transfer channels 2a are not formed, more specifically, in a region overlapping a place where the bus line wires 16a to 16d are formed, in the semiconductor substrate thickness direction, widths of the first vertical transfer electrodes 6 and widths of the second vertical transfer electrodes 9 are under only small constrictions. Therefore, each of areas for forming the contact holes 18a and 18b is larger as compared with the conventional example 2. For instance, in the case where the pixel size is 3 µm square, portions of the first and second vertical transfer electrodes 6 and 9 for contact with the vertical bus line wires 16a to 16d are allowed to have a width of 1 µm each surely. Consequently, the contact holes 18a and 18b can be formed easily in a size of 0.3 µm square or larger each.

As described above, according to Embodiment 1, the degree of freedom in the design of the vertical CCDs 2 and the horizontal bus line part 16 can be increased as compared with the conventional examples 1 and 2, whereby the micromanufacturing of pixels is facilitated. Besides, according to Embodiment 1, unlike the conventional example 2, edge portions of the second vertical transfer electrodes 9 do not overlap the first vertical transfer electrodes 6, and this reduces interlayer capacitances C between the vertical transfer electrodes in the vertical CCDs 2. This, in turn, reduces the power consumption (=4CV²f) due to the interlayer capacitances C, as compared with the conventional example 1. It should be noted that in the vertical CCDs 2, a voltage V is set to 4 V to 10 V, preferably 6 V to 8 V Further, a frequency f is set to 1 kHz to 100 kHz, preferably 5 kHz to 30 kHz.

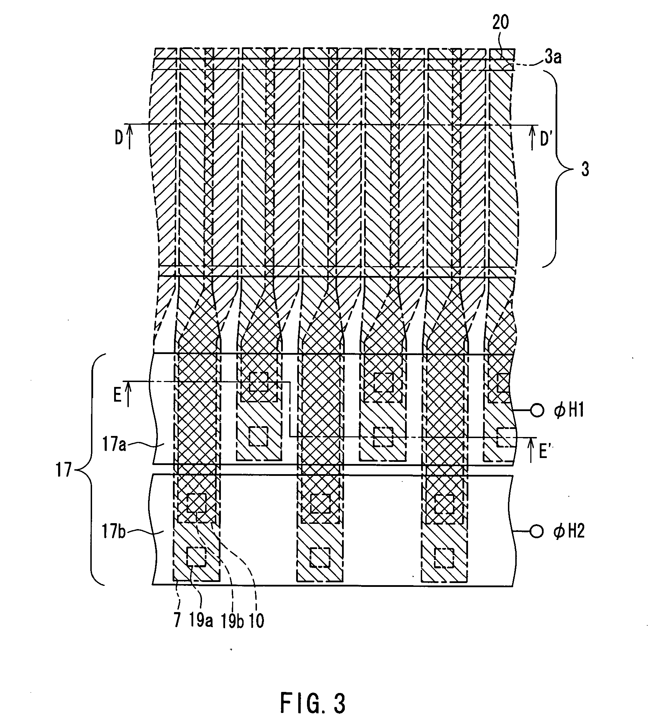

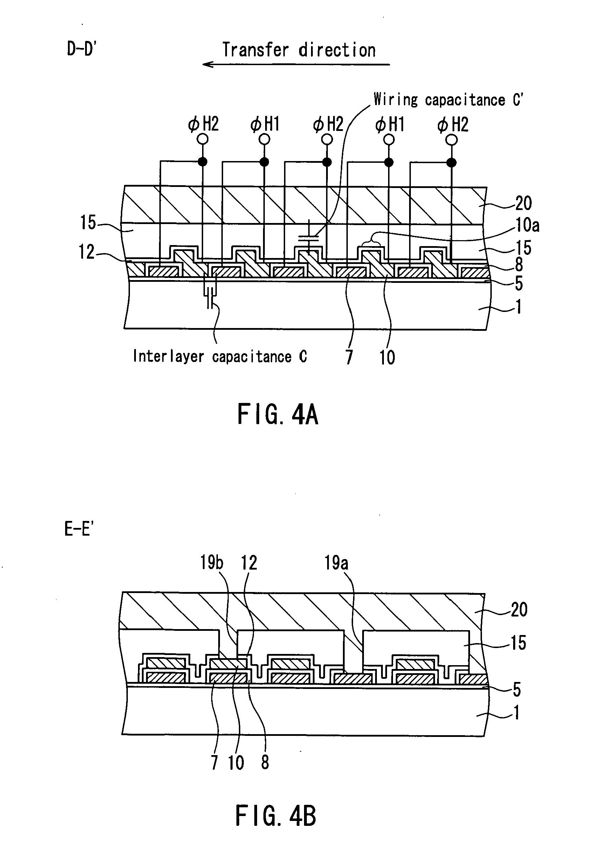

Next, a horizontal CCD of Embodiment 1 is described. FIG. 3 is a plan view illustrating a configuration of the horizontal CCD and a horizontal bus line part of the solid-state imaging device according to Embodiment 1 of the present invention. FIGS. 4A and 4B are cross-sectional views obtained by cutting the horizontal CCD and the horizontal bus line part shown in FIG. 3. FIG. 4Ais a cross-sectional view taken along a cutting line D-D', and FIG. 4B is a cross-sectional view taken along a cutting line E-E'. It should be noted that in FIGS. 4A and 4B also, only conductive members (excluding the semiconductor substrate) are hatched.

As shown in FIG. 3, also in Embodiment 1, like in the conventional examples 1 and 2 described in the "Description of Related Art" section, the horizontal CCD 3 is provided with a transfer channel 3a formed in the horizontal direction, as well as the first transfer electrode 7 and the second transfer electrodes 10 that are formed so as to cross the transfer channel 3a. The transfer channel 3a also is formed in the semiconductor substrate 1 (see FIGS. 4A and 4B). It should be noted that hereinafter the first transfer electrodes 7 of the horizontal CCD 3 are referred to as "first horizontal transfer electrodes" 7 and the second transfer electrodes 10 of the horizontal CCD 3 are referred to as "second horizontal transfer electrodes" 10.

Further, as will be describe later, the first horizontal transfer electrodes 7 are formed through the same process for forming the first vertical transfer electrode 6, and the second horizontal transfer electrodes 10 are formed through the same process for forming the second vertical transfer electrodes 9. Therefore, the first horizontal transfer electrodes 7 also are formed on the gate insulation film 5 of the semiconductor substrate 1. Still further, the insulation between the first horizontal transfer electrodes 7 and the second horizontal transfer electrodes 10 also is provided by the first interlayer insulation films 8. In a region where the transfer channel 3a is formed, the first horizontal transfer electrodes 7 and the second horizontal transfer electrodes 10 are arranged so as to be adjoined to each other.

Still further, in Embodiment 1, the horizontal bus line part 17 includes horizontal bus line wires 17a and 17b, to which different transfer pulses ΦH1 and ΦH2 are supplied, respectively. The first horizontal transfer electrodes 7 are connected with the horizontal bus line wires 17a or 17b via contact holes 19a. The second vertical transfer electrodes 9 are connected with the horizontal bus line wires 17a or 17b via contact holes 19b.

One first horizontal transfer electrodes 7 and one second horizontal transfer electrode 10 neighboring to each other form a pair, and each such pair is connected with the same horizontal bus line wire 17a or 17b. Therefore, the same transfer pulse is applied to the first and second horizontal transfer electrodes 7 and 10 in pair. On the other hand, to the first and second horizontal transfer electrodes 7 and 10 that are neighboring to each other but in different pairs, different transfer pulses are applied, respectively.

Still further, in Embodiment 1 also, as shown in FIG. 4A, a shielding film 20 is formed over a third interlayer insulation film 15 in the region where the transfer channel 3a is formed. The shielding film 20 is formed through the same process and with the same metal material as those for the horizontal bus line wires 17a and 17b.

However, the configuration of the horizontal CCD 3 and the horizontal bus line part 17 of the solid-state imaging device according to Embodiment 1 differs from those of the conventional examples 1 and 2 described in the "Description of Related Art" section in the following point. Namely, in Embodiment 1, as shown in FIGS. 3 and 4B, in the region where the transfer channel 3a is not formed, for instance in a region where the horizontal bus line part 17 is formed, the plurality of first horizontal transfer electrodes 7 and the plurality of second horizontal transfer electrodes 10 are arranged so that the latter are positioned above the former.

Therefore, in the region where the transfer channel 3a is not formed, widths of the first and second horizontal transfer electrodes 7 and 10 are under only small constrictions. Accordingly, each of areas for forming the contact holes 19a and 19b is larger as compared with the conventional example 2. For instance, in the case where the pixel size is 3 µm square, portions of the first and second horizontal transfer electrodes 7 and 10 for contact with the horizontal bus line wires 17a and 17b are allowed to have a width of 1 µm surely. Consequently, the contact holes 19a and 19b can be formed easily in a size of 0.3 µm square or larger each.

As described above, according to Embodiment 1, even in the case where the pitches of the first horizontal transfer electrodes 7 and pitches of the second horizontal transfer electrodes 10 decrease due to further densification of pixels, the degree of freedom in the design of the horizontal bus line part 17 can be increased as compared with the conventional example 2, whereby the micromanufacturing of pixels is facilitated.

Besides, in Embodiment 1, as shown in FIGS. 3 and 4A, the second horizontal transfer electrodes 10 are formed so that portions thereof in the region where the transfer channel 3a is formed do not overlap, in the semiconductor substrate 1 thickness direction, the first horizontal transfer electrodes 7 to which a different transfer pulse is applied. In other words, in Embodiment 1, among the both edges of each second horizontal transfer electrode 10, only the edge 10a thereof on the side of the first horizontal transfer electrode 7 to be connected with the same horizontal bus line wire protrudes over the first horizontal transfer electrode 7.

Therefore, according to Embodiment 1, interlayer capacitances C between the horizontal transfer electrodes in the horizontal CCD 3 can be reduced, as compared with the conventional example 1. This makes it possible to reduce the power consumption (= 2CV²f) due to the interlayer capacitances C, as compared with the conventional example 1, which reduces the power consumption of the horizontal CCD. It should be noted that in the horizontal CCD 3, the voltage V is set to 1 V to 5 V, preferably approximately 3 V. The frequency f is set to 1 kHz to 100 kHz, preferably 10 kHz to 40 kHz.

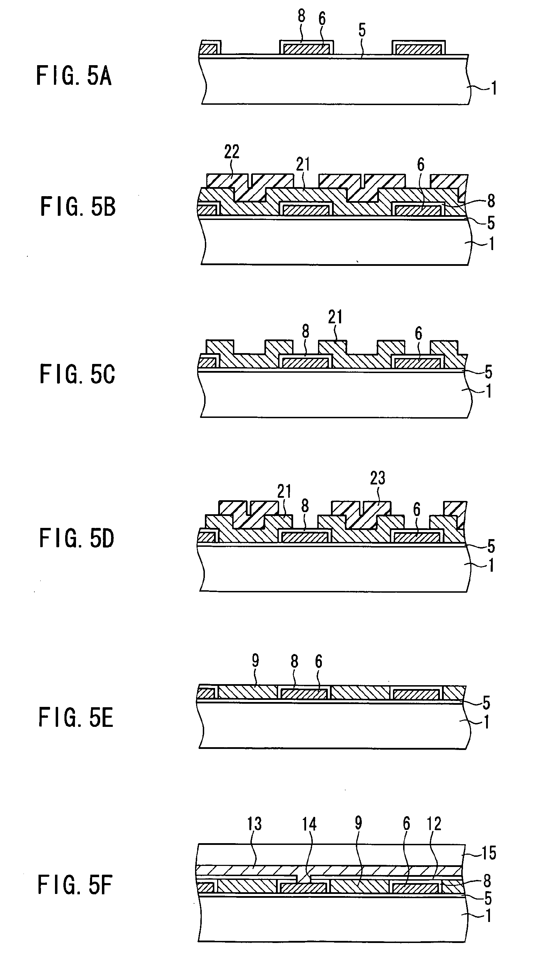

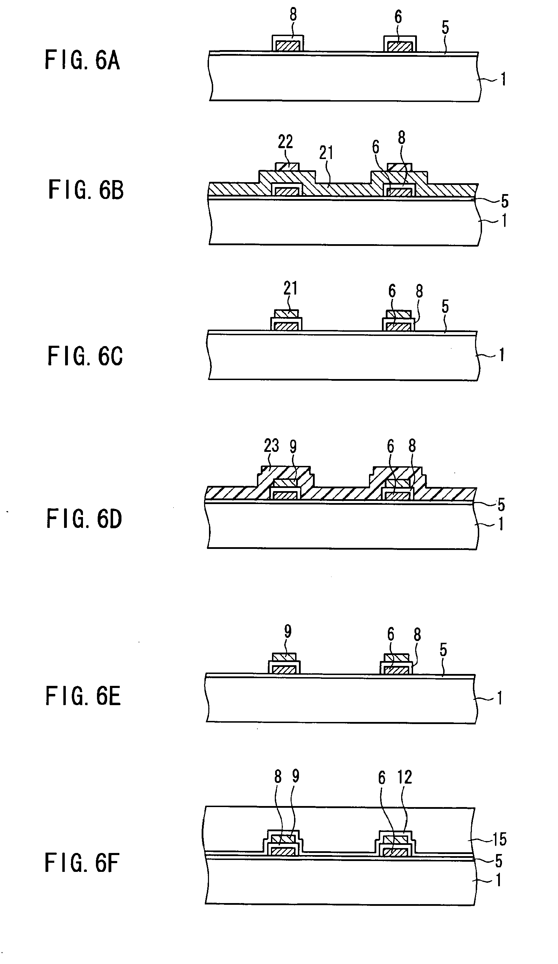

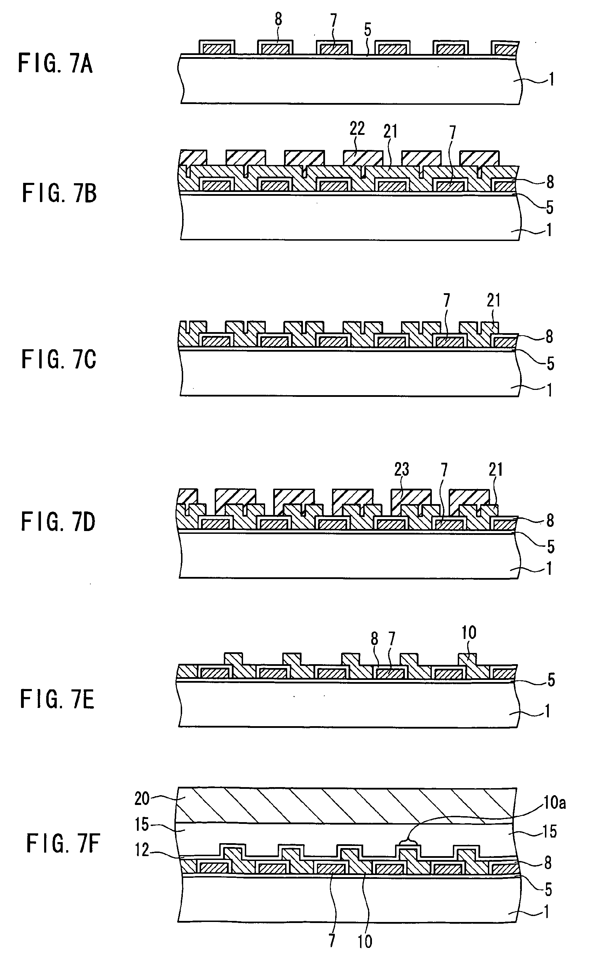

Next, a solid-state imaging device manufacturing method according to Embodiment 1 is described, with reference to FIGS. 5 to 7. FIGS. 5 to 7 are cross-sectional views illustrating a method for manufacturing the solid-state imaging device shown in FIGS. 1 to 4. FIGS. 5A to 5F illustrate major steps in sequence, respectively. Likewise, FIGS. 6A to 6F and FIGS. 7A to 7F also illustrate the same major steps in sequence. FIGS. 5A to 5F correspond to the cross-sectional view of FIG. 2A, FIGS. 6A to 6F correspond to the cross-sectional view of FIG. 2B, and FIGS. 7A to 7F correspond to the cross-sectional view of FIG. 4A. It should be noted that in FIGS. 5 to 7, only conductive members (excluding the semiconductor substrate) and resist patterns are hatched.

First, an impurity is implanted by ion implantation in the semiconductor substrate 1 such as a silicon substrate so that photoelectric conversion parts 11a (see FIG. 1), pixel separation parts 11c (see FIG. 1), transfer channels 2a, a transfer channel 3a (see FIGS. 1 and 3), and the like are formed. Subsequently, as shown in FIGS. 5A, 6A, and 7A, an oxide film, a nitride film, or the like is formed to provide a gate insulation film 5 on a surface of the semiconductor substrate 1 by thermal oxidation or low-pressure CVD. Thereon, a polysilicon film or the like is formed as a first conductive film by low-pressure CVD. The first conductive film is to be formed into the first vertical transfer electrodes 6 or the first horizontal transfer electrodes 7.

Subsequently, photolithography and RIE (reactive ion etching) are performed for forming a resist pattern and removing unnecessary portions of the first conductive film. By so doing, the first vertical transfer electrodes 6 and the first horizontal transfer electrodes 7 are formed with predetermined spaces being provided therebetween. Thereafter, by thermal oxidation or the like, first interlayer insulation films 8 are formed around each of the first vertical transfer electrodes 6 and the first horizontal transfer electrodes 7.

Next, as shown in FIGS. 5B, 6B, and 7B, a second conductive film 21 such as a polysilicon film is formed on the first vertical transfer electrodes 6 and the first horizontal transfer electrodes 7 by low-pressure CVD. The second conductive film 21 is formed into the second vertical transfer electrodes 9 and the second horizontal transfer electrodes 10.

Subsequently, a resist pattern 22 is formed by photolithography. In regions where the transfer channels 2a and 3a are not formed, the resist pattern 22 is formed so as to mask regions above the first vertical transfer electrodes 6 and the first horizontal transfer electrodes 7 (see FIG. 6B). On the other hand, in regions where the transfer channels 2a and the transfer channel 3a are formed, the resist pattern 22 is formed so as to have openings in regions above the first vertical transfer electrodes 6 and the first horizontal transfer electrodes 7 (see FIGS. 5B and 7B).

Next, as shown in FIGS. 5C, 6C, and 7C, anisotropic etching is carried out by using the resist pattern 22 as a mask, for removing unnecessary portions of the second conductive film 21. More specifically, RIE is carried out. By so doing, in the regions where the transfer channels 2a and the transfer channel 3a are not formed, the second conductive films 21 remain only above the first vertical transfer electrodes 6 and the first horizontal transfer electrodes 7 (see FIG. 6C). Besides, in the regions where the transfer channels 2a and the transfer channel 3a are formed, edges of the first vertical transfer electrodes 6 or the first horizontal transfer electrodes 7 and the second conductive film 21 overlap each other (see FIGS. 5C and 7C). After the completion of RIE, the resist pattern 22 is removed.

Next, as shown in FIGS. 5D, 6D, and 7D, a resist pattern 23 is formed by photolithography. In regions where the transfer channels 2a of the vertical CCDs are formed, the resist pattern 23 is formed so as to have openings in regions above portions of the second conductive films 21 that overlap the first interlayer insulation films 8 (the first vertical transfer electrodes 6) in the semiconductor substrate 1 thickness direction (see FIG. 5D).

Besides, in the region where the transfer channel 3a of the horizontal CCD is formed, the resist pattern 23 is formed so as to have openings such that portions of the second conductive films 21 that overlap the first interlayer insulation films 8 (the first horizontal transfer electrodes 7) in the semiconductor substrate 1 thickness direction are uncovered partially (see FIG. 7D). In the present example, the resist pattern 23 has openings such that a top face of an edge portion of each first horizongal transfer electrode 7 is not covered, the edge portion being on a side of the second conductive film 21 not to be connected with the same horizontal bus line wire.

Subsequently, isotropic etching is carried out by using the resist pattern 23 as a mask. Here, the second conductive films 21 are etched not only under the openings of the resist pattern 23, but the etching also progresses in the lateral direction. As a result, the second conductive films 21 have top faces substantially at the same height as the top faces of the first interlayer insulation films 8. Then, the resist pattern 23 is removed. Consequently, as shown in FIGS. 5E, 6E, and 7E, the second vertical transfer electrodes 9 and the second horizontal transfer electrodes 10 are formed at the same time.

Thereafter, as shown in FIGS. 5F, 6F, and 7F, a second interlayer insulation film 12, a third interlayer insulation film 15, contact holes 14a, 14b, 19a, and 19b, and shielding films 13 are formed. The shielding films 13 are formed with, for instance, a metal material such as aluminum or tungsten. Though not shown, contact holes 18a and 18b, vertical bus line wires 16a to 16d, and horizontal bus line wires 17a and 17b are formed. Further, a shielding film 20 is formed. As a result, the solid-state imaging device shown in FIGS. 1 to 4 is obtained.

Thus, by carrying out the solid-state imaging device manufacturing method according to Embodiment 1, the solid-state imaging device according to Embodiment 1 shown in FIGS. 1 to 4 is obtained. According to the solid-state imaging device manufacturing method according to Embodiment 1, edges of the second vertical transfer electrodes 9 overlapping the first vertical transfer electrodes 6 and edges of the second horizontal transfer electrodes 10 overlapping the first horizontal transfer electrodes 7 can be removed without carrying out CMP as in the conventional example 2. Therefore, the thicknesses of the second conductive films 21 are prevented from varying with the density of patterns of the first vertical transfer electrodes 6 and the first horizontal transfer electrodes 7 as in the conventional example 2, and consequently the second vertical transfer electrodes 9 and the second horizontal transfer electrodes 10 with uniform film thicknesses can be obtained. Thus, according to Embodiment 1, it is possible to avoid an increase in the power consumption due to increased resistance variation in the second vertical transfer electrodes 9 and the second horizontal transfer electrodes 10.

It should be noted that in Embodiment 1, the first transfer electrodes and the second transfer electrodes do not overlap each other in the semiconductor substrate 1 thickness direction in both of the vertical CCD 2 and the horizontal CCD 3, but the embodiment is not limited to this. The embodiment may be such that the first transfer electrodes and the second transfer electrodes do not overlap each other in the semiconductor substrate thickness direction in only either the vertical CCD or the horizontal CCD.

For instance, if the intent only is to facilitate the formation of the contact holes 14a for connection with the first vertical transfer electrodes 6, only the overlap of the first vertical transfer electrodes 6 and the second vertical transfer electrodes 9 may be avoided. Alternatively, if the intent only is to reduce the power consumption of the horizontal CCD 3, only the overlap of the first horizontal transfer electrodes 7 and the second horizontal transfer electrodes 10 may be avoided. One of such embodiments may be selected independently as required.

### Embodiment 2

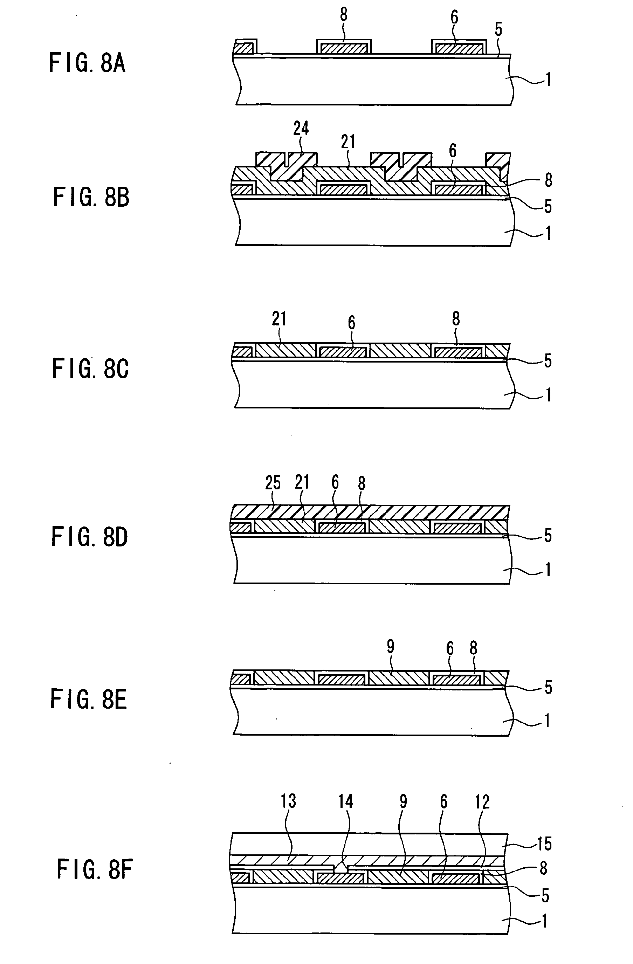

The following describes a solid-state imaging device and a solid-state imaging device manufacturing method according to Embodiment 2 of the present invention, while referring to FIGS. 8 to 12. The solid-state imaging device according to Embodiment 2 has the same configuration as the solid-state imaging device according to Embodiment 1 shown in FIGS. 1 to 4. However, the solid-state imaging device manufacturing method according to Embodiment 2 differs from that of Embodiment 1 in the following point.

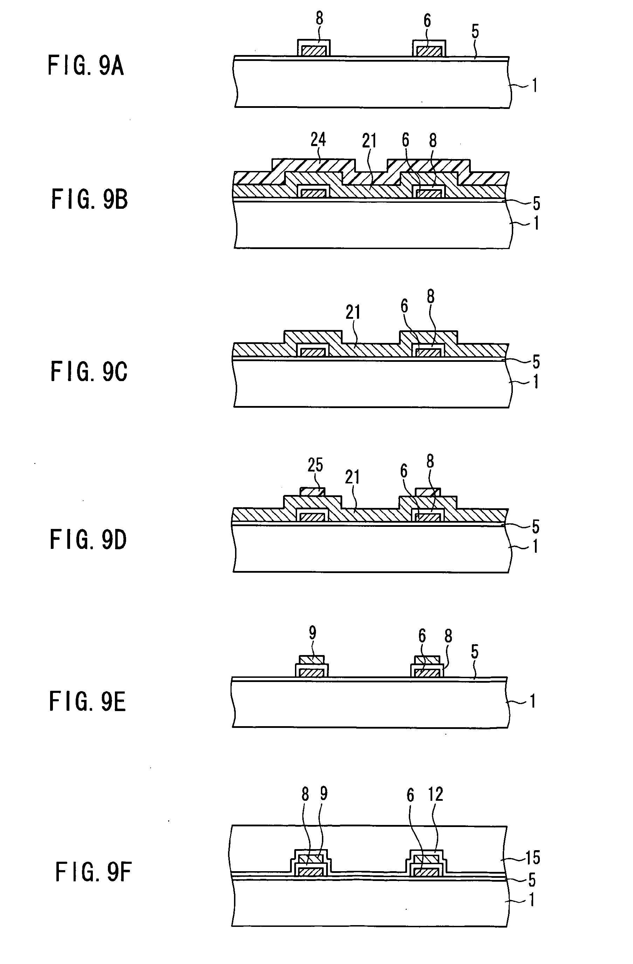

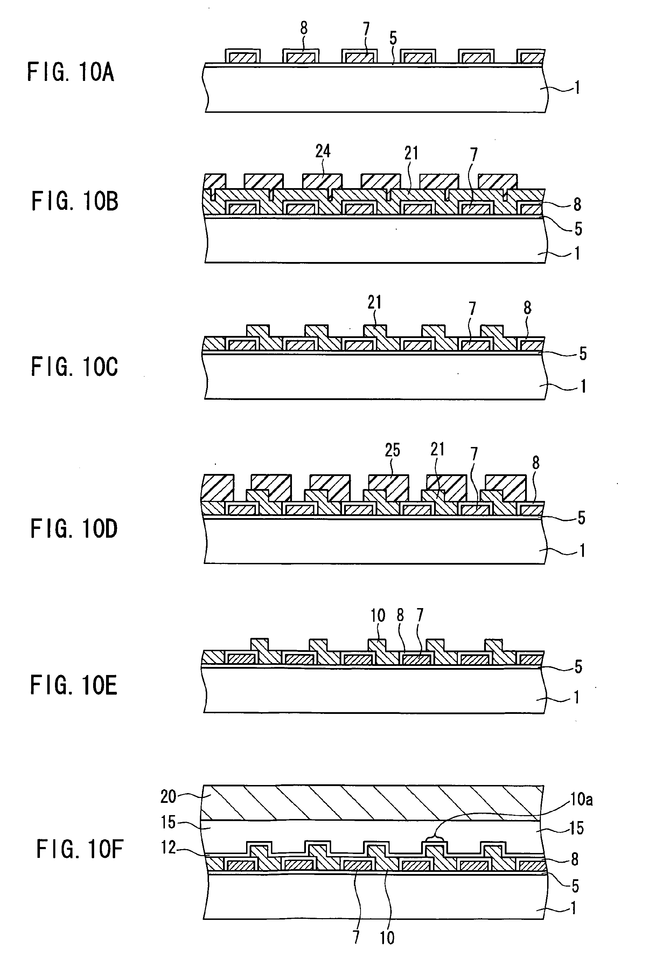

The following describes the solid-state imaging device manufacturing method according to Embodiment 2 while referring to FIGS. 8 to 10. FIGS. 8 to 10 are cross-sectional views illustrating a method for manufacturing the solid-state imaging device according to Embodiment 2. FIGS. 8A to 8F illustrate major steps in sequence, respectively. Likewise, FIGS. 9A to 9F and FIGS. 10A to 10F also illustrate the same major steps in sequence. FIGS. 8A to 8F correspond to the cross-sectional view of FIG. 2A, FIGS. 9A to 9F correspond to the cross-sectional view of FIG. 2B, and FIGS. 10A to 10F correspond to the cross-sectional view of FIG. 4A. It should be noted that in FIGS. 8 to 10, only conductive members (excluding the semiconductor substrate) and resist patterns are hatched.

First, as shown in FIGS. 8A, 9A, and 10A, a gate insulation film 5, first vertical transfer electrodes 6, first horizontal transfer electrodes 7, and first interlayer insulation films 8 are formed on a semiconductor substrate 1 in which transfer channels 2a and the transfer channel 3a (see FIGS. 1 and 3), etc. are formed. It should be noted that the step shown in FIGS. 8A, 9A, and 10A is performed in the same manner as the step of Embodiment 1 shown in FIGS. 5A, 6A, and 7A.

Next, as shown in FIGS. 8B, 9B, and 10B, a second conductive film 21 is formed by low-pressure CVD over the first vertical transfer electrodes 6 and the first horizontal transfer electrodes 7. Subsequently, a resist pattern 24 is formed by photolithography. The resist pattern 24 is identical to the resist pattern 23 of Embodiment 1 shown in FIGS. 5D, 6D, and 7D.

More specifically, in regions where the transfer channels 2a of the vertical CCDs are formed, the resist pattern 24 is formed so as to have openings above portions of the second conductive film 21 overlapping the first interlayer insulation films 8 (the first vertical transfer electrodes 6) in the semiconductor substrate 1 thickness direction (see FIG. 8B).

Further, as shown in FIG. 10B, in a region where the transfer channel 3a of the horizontal CCD is formed, the resist pattern 24 is formed so as to have openings such that portions of the second conductive film 21 that overlap the first interlayer insulation films 8 (the first horizontal transfer electrodes 7) in the semiconductor substrate 1 thickness direction are not covered partially. In the example shown in FIG. 10B also, like in the example shown in FIG. 7D, the resist pattern 24 has openings such that a top face of an edge portion of each first horizontal transfer electrode 7 is not covered, the edge portion being on a side of the part of the second conductive film 21 not to be connected with the same horizontal bus line wire.

Subsequently, as shown in FIGS. 8C, 9C, and 10C, isotropic etching is carried out by using the resist pattern 24 as a mask. Here also, like in the step of Embodiment 1 shown in FIGS. 5D and 7D, the second conductive film 21 is etched not only under the openings of the resist pattern 24, but the etching also progresses in the lateral direction. As a result, the second conductive film 21 has a top face substantially at the same height as the top faces of the first interlayer insulation films 8. Then, the resist pattern 24 is removed.

Next, as shown in FIGS. 8D, 9D, and 10D, a resist pattern 25 is formed by photolithography. In regions where the transfer channels 2a and the transfer channel 3a are not formed, like the resist pattern 22 of Embodiment 1 shown in FIGS. 5B, 6B, and 7B, the resist pattern 25 is formed so that regions above the first vertical transfer electrodes 6 and the first horizontal transfer electrodes 7 are masked (see FIG. 9D).

It should be noted that, in the regions where the transfer channels 2a are formed, the resist pattern 25 is formed so as to cover the foregoing regions and regions surrounding the same entirely (see 8D). Besides, in the region where the transfer channel 3a is formed, the resist pattern 25 is formed so that portions of the second conductive film 21 overlapping the first horizontal transfer electrodes 7 are uncovered partially (see FIG. 10D).

Subsequently, anisotropic etching is carried out by using the resist pattern 25 as a mask, for removing unnecessary portions of the second conductive film 21. More specifically, RIE is carried out. Then, the resist pattern 25 is removed. As a result, the second vertical transfer electrodes 9 and the second horizontal transfer electrodes 10 are formed at the same time, as shown in FIGS. 8E, 9E, and 10E.

Thereafter, by carrying out the step shown in FIGS. 8F, 9F, and 10F, the solid-state imaging device of Embodiment 1 shown in FIG. 1 to 4 can be obtained in Embodiment 2 also. It should be noted that the step shown in FIGS. 8F, 9F, and 10F is carried out in the same manner as the step shown in FIGS. 5F, 6F, and 7F.

Thus, the solid-state imaging device manufacturing method according to Embodiment 2 is characterized in that the second vertical transfer electrodes 9 and the second horizontal transfer electrodes 10 are formed by carrying out anisotropic etching after carrying out isotropic etching, which is a point that distinguishes the solid-state imaging device manufacturing method of Embodiment 2 from that of Embodiment 1. In other words, in Embodiment 2, the portions of the second conductive film 21 corresponding to the edges 109a of the second vertical transfer electrodes 109 and the edges 110a of the second horizontal transfer electrodes 110 shown in FIG. 24A regarding the prior art are removed in advance. Thereafter, the finishing patterning is performed with respect to the second conductive film 21.

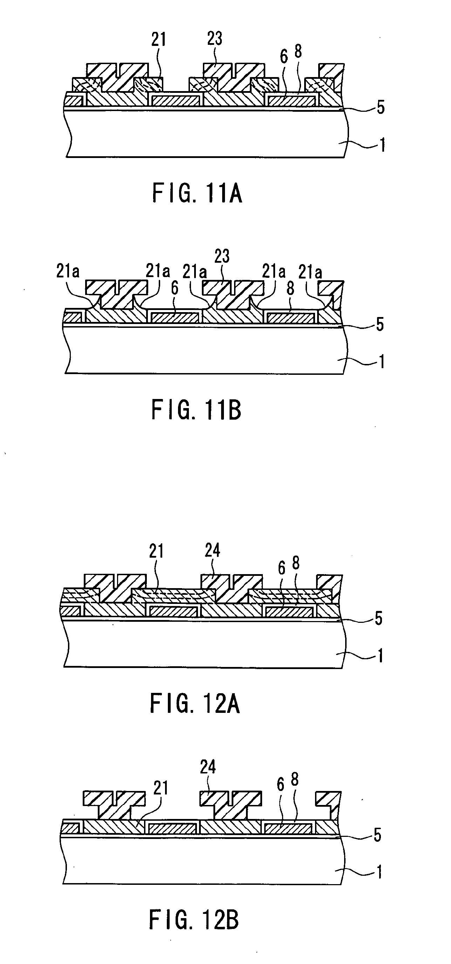

Therefore, by the solid-state imaging device manufacturing method according to Embodiment 2, an excellent effect can be achieved further in addition to the effect described regarding Embodiment 1. The following describes this effect while referring to FIGS. 11 and 12. FIGS. 11A and 11B are cross-sectional views illustrating the step shown in FIG. 5D in Embodiment 1 in more detail. FIGS. 11A and 11B show the states prior to and after the isotropic etching, respectively. FIGS. 12A and 12B are cross-sectional views illustrating the step shown in FIG. 8B in Embodiment 2 in more detail. FIGS. 12A and 12B show the states prior to and after the isotropic etching, respectively. It should be noted that in FIGS. 11 and 12, only conductive members (excluding the semiconductor substrate) are hatched. Broken lines in FIGS. 11 and 12 indicate the progress of the etching conceptually

As shown in FIG. 11A, in Embodiment 1, when isotropic etching is carried out by using the resist pattern 23 as a mask, the second conductive film 21 is etched in two directions simultaneously, i.e., from above and in the lateral direction. Therefore, in Embodiment 1, as shown in FIG. 11B, even if portions of the second conductive film 21 overlapping the first vertical transfer electrodes 6 are removed completely, sometimes small projections 21a remain in the vicinities of borders between the resist pattern 23 and the second conductive film 21.

In contrast, in Embodiment 2, as shown in FIG. 12A, isotropic etching is carried out in a state in which top faces of the first interlayer insulation films 8 entirely are covered with the second conductive film 21. Therefore, the second conductive film 21 is etched from above first, and thereafter etched in two directions, i.e., from above and in the lateral direction. Therefore, when portions of the second conductive film 21 overlapping the first vertical transfer electrodes 6 are removed completely, projections 21a as shown in FIG. 11B hardly are formed, and top faces of the second vertical transfer electrodes 9 are made substantially flat, whereby the heights thereof are identical to that of the first interlayer insulation films 8. For this reason, according to Embodiment 2, transfer electrodes can be formed with fewer steps, as compared with Embodiment 1.

### Embodiment 3

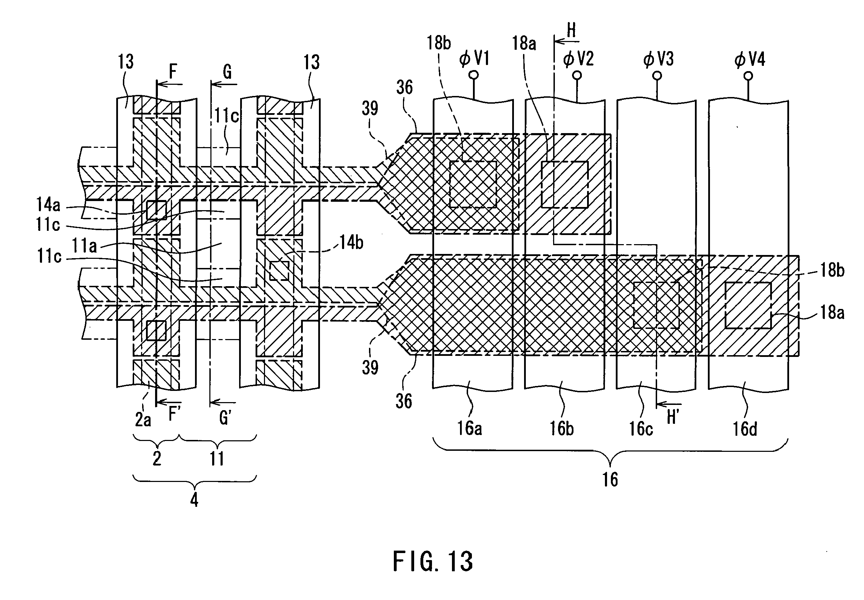

The following describes a solid-state imaging device and a solid-state imaging device manufacturing method according to Embodiment 3 of the present invention, while referring to FIGS. 13 to 20. First, the configuration of the solid-state imaging device according to Embodiment 3 is described, with reference to FIGS. 13 to 17.

The solid-state imaging device according to Embodiment 3 differs from the solid-state imaging device according to Embodiment 1 regarding the configurations of the first vertical transfer electrodes, the second vertical transfer electrodes, the first horizontal transfer electrodes, and the second horizontal transfer electrodes, but regarding the items other than those, the solid-state imaging device according to Embodiment 3 is configured in the same manner as the solid-state imaging device according to Embodiment 1.

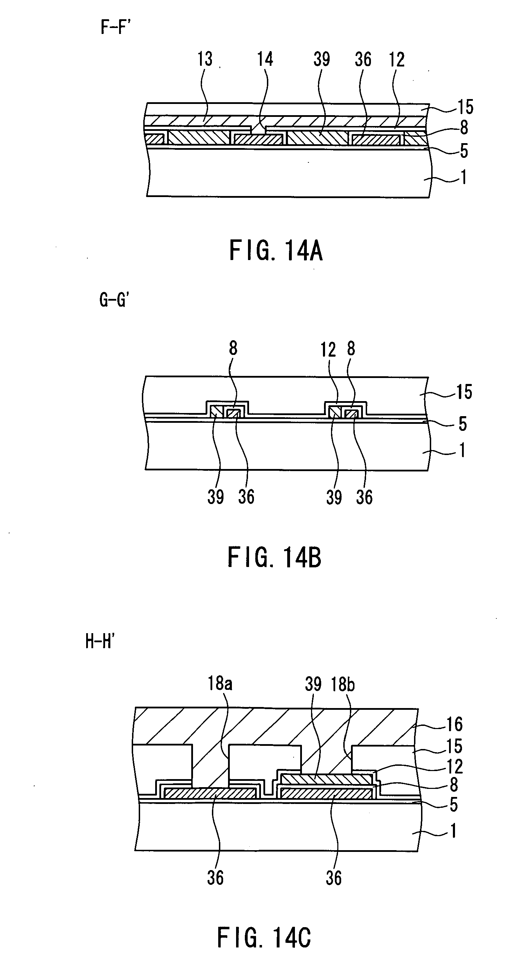

The configuration of the solid-state imaging device in Embodiment 3 is described, regarding each part thereof. First, a vertical CCD in Embodiment 3 is described. FIG. 13 is a plan view illustrating a configuration of vertical CCDs and a vertical bus line part of the solid-state imaging device of Embodiment 3 of the present invention. FIGS. 14A to 14C are cross-sectional views obtained by cutting the vertical CCDs and the vertical bus line part shown in FIG. 13. FIG. 14A is a cross-sectional view taken along a cutting line F-F', FIG. 14B is a cross-sectional view taken along a cutting line G-G', and FIG. 14C is a cross-sectional view taken along a cutting line H-H'. It should be noted that in FIGS. 14A to 14C also, only conductive members (excluding the semiconductor substrate) are hatched.

As shown in FIGS. 13 and 14A, in Embodiment 3 also, like in Embodiment 1, second vertical transfer electrodes 39 are formed so that portions thereof in regions where transfer channels 2a are formed do not overlap first vertical transfer electrodes 36 in the semiconductor substrate 1 thickness direction. Further, as shown in FIGS. 13 and 14C, in Embodiment 3 also, like in Embodiment 1, in a region where a vertical bus line part 16 is formed, the first and second vertical transfer electrodes 36 and 39 are arranged so that the second vertical transfer electrodes 39 are positioned above the first vertical transfer electrodes 36.

Therefore, in the solid-state imaging device of Embodiment 3 also, like in Embodiment 1, the degree of freedom in the design of the vertical CCDs 2 and the horizontal bus line part 16 is increased as compared with the conventional examples 1 and 2, whereby the micromanufacturing of pixels is facilitated. Besides, like in Embodiment 1, interlayer capacitances C between the vertical transfer electrodes in the vertical CCDs 2 can be reduced, whereby the power consumption of the vertical CCDs 2 can be reduced.

However, as shown in FIGS. 13 and 14B, in Embodiment 3, unlike in Embodiment 1, the second vertical transfer electrodes 39 are formed so that portions thereof in regions where pixel separation parts 11c are formed do not overlap the first vertical transfer electrodes 36 in the semiconductor substrate 1 thickness direction, either. In Embodiment 3, the second vertical transfer electrodes 39 are positioned above the first vertical transfer electrodes 36 exclusively in a region overlapping the area in which the bus line wires 16a to 16d are formed, in the semiconductor substrate thickness direction, and in the vicinities of the foregoing region.

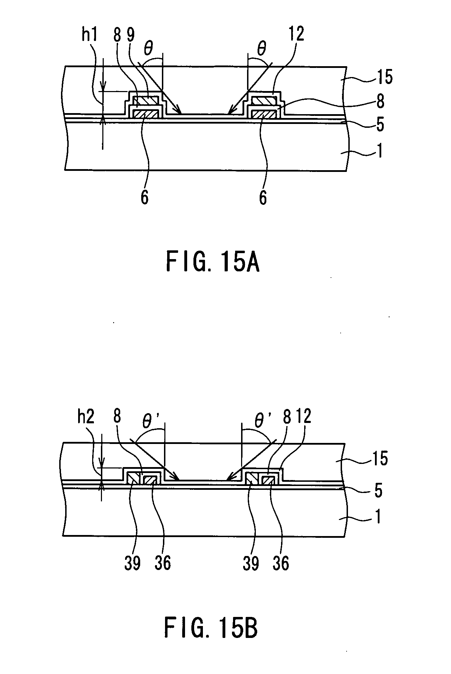

Therefore, according to Embodiment 3, as shown in FIG. 14B, in a region where the pixel separation parts 11c are formed, steps created by the first and second vertical transfer electrodes 36 and 39 are reduced as compared with Embodiment 1. This point is described below with reference to FIGS. 15A and 15B.

FIGS. 15A and 15B are cross-sectional views illustrating cross-sectional configuration of the pixel separation parts in Embodiments 1 and 3. FIG. 15A is a cross-sectional view illustrating the cross-sectional configuration of the pixel separation part of the solid-state imaging device of Embodiment 1, and FIG. 15B is a cross-sectional view illustrating the cross-sectional configuration of the pixel separation part of the solid-state imaging device of Embodiment 3. It should be noted that FIG. 15A corresponds to FIG. 2B, and FIG. 15B corresponds to FIG. 14B. In FIGS. 15A and 15B also, only conductive members (excluding the semiconductor substrate) are hatched.

As shown in FIG. 15A, in Embodiment 1, the second vertical transfer electrodes 9 are formed so that portions thereof in regions where the pixel separation parts 11c are formed are positioned above the first vertical transfer electrodes 6. In contrast, as shown in FIG. 15B, in Embodiment 3, the second vertical transfer electrodes 39 are formed so that portions thereof in regions where the pixel separation parts 11c are formed do not overlap the first vertical transfer electrodes 36. Therefore, the height h2 of the steps in Embodiment 3 is smaller than the height h1 of the steps in Embodiment 1. In other words, according to Embodiment 3, steps in regions around the photoelectric conversion parts 11a (see FIGS. 1 and 13) can be lowered.

Therefore, as shown in FIGS. 15A and 15B, the incident angle θ' of light that can be focused in the photoelectric conversion parts 11a in Embodiment 3 can be increased as compared with the incident angle θ of light that can be focused in the photoelectric conversion parts 11a in Embodiment 1. Thus, according to Embodiment 3, the sensitivity of pixels can be enhanced as compared with Embodiment 1.

Further, since the steps in regions around the photoelectric conversion parts 11a (see FIGS. 1 and 13) can be lowered, in the case where the shielding films 13 are composed of a plurality of strap-form parts (see FIGS. 1, 13, and 21), the formation of spaces between neighboring strap-form parts is facilitated. This also prevents the shielding films 13 from being short-circuited.

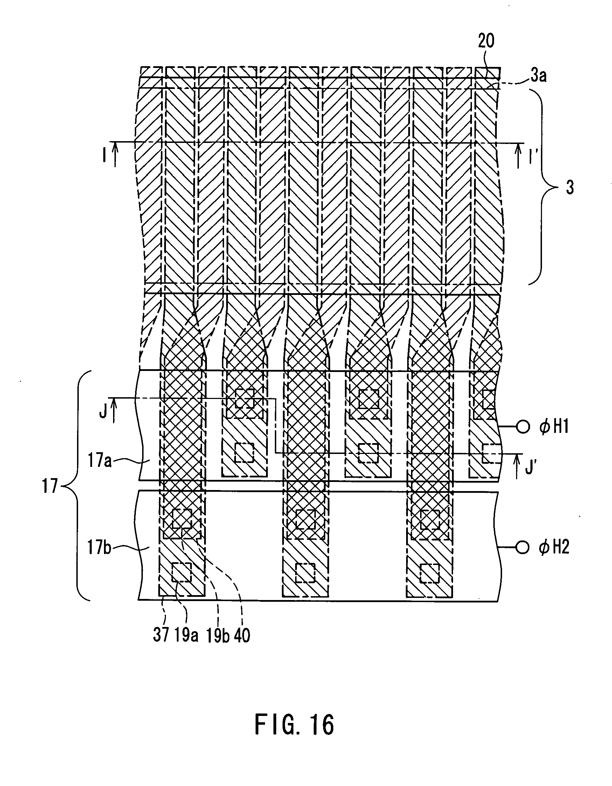

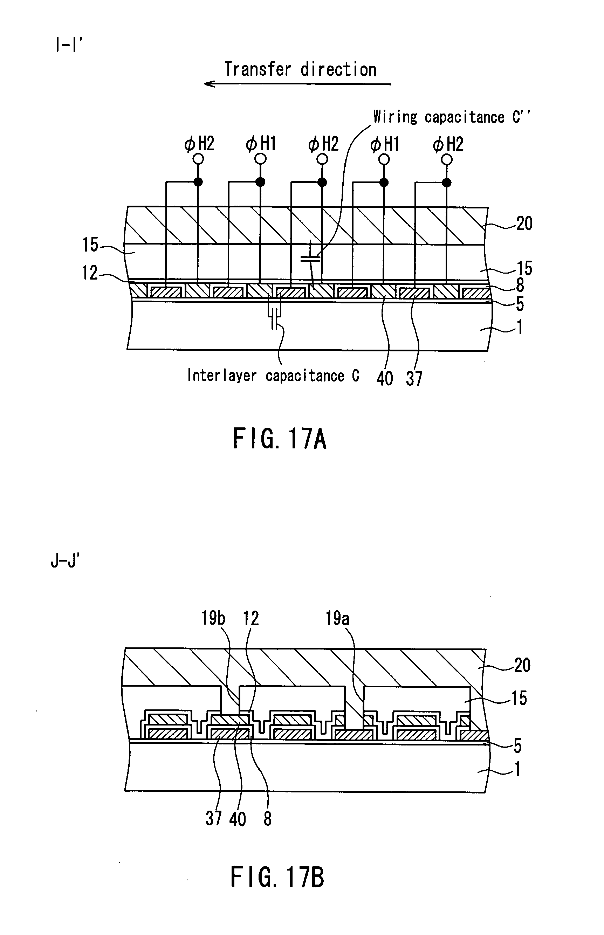

Next, a horizontal CCD in Embodiment 3 is described. FIG. 16 is a plan view illustrating a configuration of the horizontal CCD and a horizontal bus line part of the solid-state imaging device according to Embodiment 3 of the present invention. FIGS. 17A and 17B are cross-sectional views obtained by cutting the horizontal CCD and the horizontal bus line part shown in FIG. 16. FIG. 17A is a cross-sectional view taken along a cutting line I-I', and FIG. 17B is a cross-sectional view taken along a cutting line J-J'. It should be noted that in FIGS. 17A and 17B also, only conductive members (excluding the semiconductor substrate) are hatched.

As shown in FIGS. 16 and 17B, in Embodiment 3 also, like in Embodiment 1, the first horizontal transfer electrodes 37 and the second horizontal transfer electrodes 40 are arranged so that in regions where the transfer channel 3a is not formed, for instance, in a region where the horizontal bus line part 17 is formed, the second horizontal transfer electrodes 40 are positioned above the first horizontal transfer electrodes 37.

Therefore, in the case where Embodiment 3 is used, like in the case of Embodiment 1, even if the pitches between the first horizontal transfer electrodes 37 and the second horizontal transfer electrodes 40 decrease due to further densification of pixels, the degree of freedom in the design of the horizontal bus line part 17 is increased as compared with the conventional example 2, whereby the micromanufacturing of pixels is facilitated.

Further, as shown in FIGS. 16 and 17A, in Embodiment 3 also, like in Embodiment 1, the second horizontal transfer electrodes 40 are formed so that portions thereof in the region where the transfer channel 3a is formed do not overlap the first horizontal transfer electrodes 37 to which a different transfer pulse is applied in the semiconductor substrate 1 thickness direction. Therefore, with the use of Embodiment 3, the interlayer capacitances C between the horizontal transfer electrodes in the horizontal CCD 3 are reduced as compared with the conventional example 1. Thus, the power consumption of the horizontal CCD 3 can be reduced.

However, as shown in FIGS. 16 and 17A, in Embodiment 3, unlike Embodiment 1, portions of the second horizontal transfer electrodes 40 in the region where the transfer channel 3a is formed do not overlap the first horizontal transfer electrodes 37 to which the same transfer pulse is applied in the semiconductor substrate 1 thickness direction, either. Therefore, according to Embodiment 3, the interlayer capacitances between the horizontal transfer electrodes in the horizontal CCD 3 are reduced further, as compared with Embodiment 1, and the power consumption of the horizontal CCD 3 is reduced further. Besides, since the steps formed due to the second horizontal transfer electrodes 40 are made smaller as compared with Embodiment 1 in the region where the transfer channel 3a is formed, wiring capacitances C" formed between the first horizontal transfer electrodes 37 and the shielding films 20, and wiring capacitances C" formed between the second horizontal transfer electrodes 40 and the shielding films 20 are reduced.

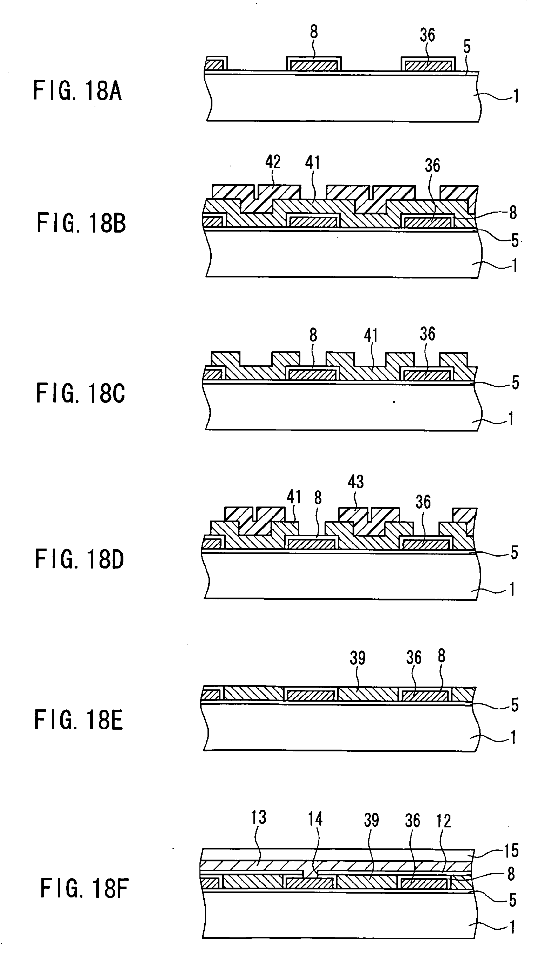

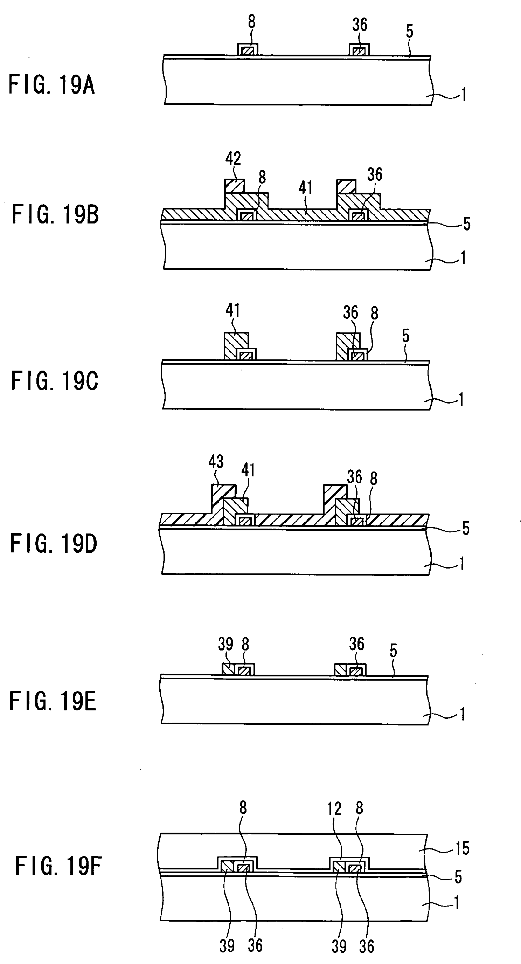

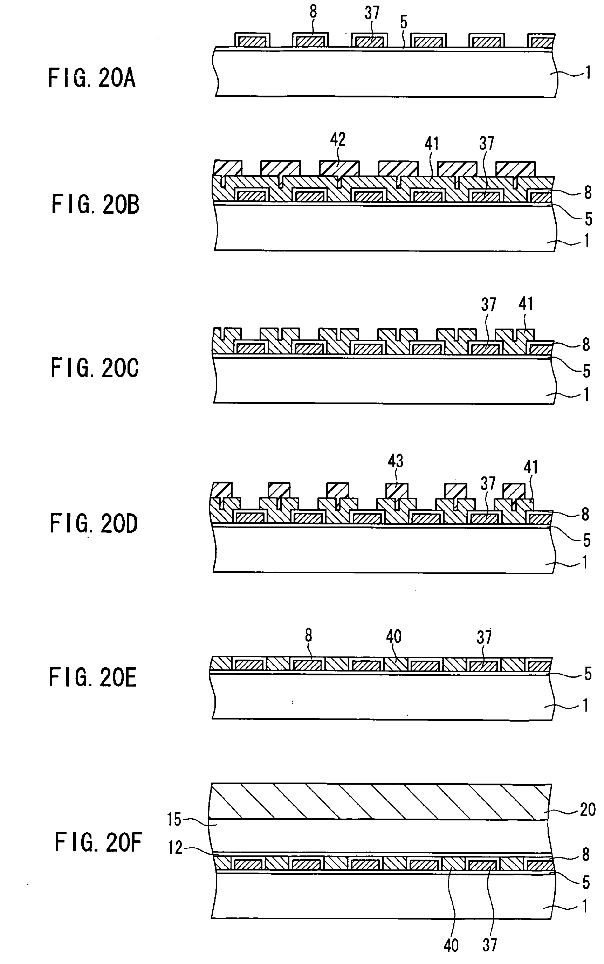

Next, a solid-state imaging device manufacturing method according to Embodiment 3 is described, with reference to FIGS. 18 to 20. FIGS. 18 to 20 are cross-sectional views illustrating a method for manufacturing the solid-state imaging device shown in FIGS. 13, 14, 16, and 17. FIGS. 18A to 18F illustrate major steps in sequence, respectively. Likewise, FIGS. 19A to 19F and FIGS. 20A to 20F also illustrate the same major steps in sequence. FIGS. 18A to 18F correspond to the cross-sectional view of FIG. 14A, FIGS. 19A to 19F correspond to the cross-sectional view of FIG. 14B, and FIGS. 20A to 20F correspond to the cross-sectional view of FIG. 17A. It should be noted that in FIGS. 18 to 20, only conductive members (excluding the semiconductor substrate) and resist patterns are hatched.

First, photoelectric conversion parts 11a (see FIG. 13), pixel separation parts 11c, transfer channels 2a and 3a (see FIGS. 13 and 16), and the like are formed in the semiconductor substrate 1. Subsequently, as shown in FIGS. 18A, 19A, and 20A, a gate insulation film 5, first vertical transfer electrodes 36, first horizontal transfer electrodes 37, and first interlayer insulation films 8 are formed on the semiconductor substrate 1. It should be noted that the step shown in FIGS. 18A, 19A, and 20A is carried out in the same manner as the step of Embodiment 1 shown in FIGS. 5A, 6A, and 7A.

Next, as shown in FIGS. 18B, 19B, and 20B, a second conductive film 41 such as a polysilicon film or the like is formed by low-pressure CVD on the first vertical transfer electrodes 36 and the first horizontal transfer electrodes 37. Subsequently, a resist pattern 42 is formed by photolithography.

In a region where the transfer channels 2a and the transfer channel 3a are not formed, excluding regions where the pixel separation parts 11c (see FIG. 13) are formed, the resist pattern 42 is formed so that regions above the first vertical transfer electrodes 36 and the first horizontal transfer electrodes 37 are masked. On the other hand, in the regions where the pixel separation parts 11c are formed, the resist pattern 42 is formed so that half of a top face of each part raised due to the first vertical transfer electrode 37 is masked, as shown in FIG. 19B. Further, in the regions where the transfer channels 2a and the transfer channel 3a are formed, the resist pattern 42 is formed so as to have openings in regions above the first vertical transfer electrodes 36 and the first horizontal transfer electrodes 37 (see FIGS. 18B and 20B).

Next, as shown in FIGS. 18C, 19C, and 20C, anisotropic etching is carried out by using the resist pattern 42 as a mask, for removing unnecessary portions of the second conductive film 41. More specifically, RIE is carried out. By so doing, in the regions where the transfer channels 2a and the transfer channel 3a are not formed, the second conductive film 41 remains only above the first vertical transfer electrodes 36 and the first horizontal transfer electrodes 37 (not shown). Besides, in the regions where the transfer channels 2a and the transfer channel 3a are formed, and in the regions where the pixel separation parts 11c are formed, edges of the first vertical transfer electrodes 36 or the first horizontal transfer electrodes 37 and the second conductive film 41 overlap each other. After the completion of RIE, the resist pattern 42 is removed.

Next, as shown in FIGS. 18D, 19D, and 20D, photolithography is carried out so that the resist pattern 43 is formed. In regions where the transfer channels 2a of the vertical CCDs are formed and regions where the pixel separation parts 11c are formed, the resist pattern 43 is formed so as to have openings above portions of the second conductive film 41 that overlap the first interlayer insulation films 8 (the first vertical transfer electrodes 36) in the semiconductor substrate 1 thickness direction (see FIG. 18D and 19D).

Further, in the region where the transfer channel 3a of the horizontal CCD is formed, the resist pattern 43 is formed so as to have openings above portions of the second conductive film 41 that overlap the first interlayer insulation films 8 (first horizontal transfer electrodes 37) in the semiconductor substrate 1 thickness direction (see FIG. 20D).

Subsequently, isotropic etching is carried out by using the resist pattern 43 as a mask. Here, the second conductive film 41 is etched not only under the openings of the resist pattern 43, but the etching also progresses in the lateral direction. As a result, the second conductive film 41 has a top face substantially at the same height as the top faces of the first interlayer insulation films 8. Then, the resist pattern 43 is removed. Consequently, as shown in FIGS. 18E, 19E, and 20E, the second vertical transfer electrodes 39 and the second horizontal transfer electrodes 40 are formed at the same time.

Thereafter, as shown in FIGS. 18F, 19F, and 20F, a second interlayer insulation film 12, a third interlayer insulation film 15, contact holes 14a, 14b, 19a, and 19b, and shielding films 13 are formed. Though not shown, contact holes 18a and 18b, vertical bus line wires 16a to 16d, and horizontal bus line wires 17a and 17b are formed. Further, a shielding film 20 is formed. As a result, the solid-state imaging device shown in FIGS. 13, 14, 16, and 17 is obtained.

Thus, according to the solid-state imaging device manufacturing method according to Embodiment 3, as in Embodiments 1 and 2, edges of the second vertical transfer electrodes 39 overlapping the first vertical transfer electrodes 36 and edges of the second horizontal transfer electrodes 40 overlapping the first horizontal transfer electrodes 37 can be removed, without carrying out CMP as in the conventional example 2. Therefore, the thickness of the second conductive film 41 is prevented from varying with the density of patterns of the first vertical transfer electrodes 36 and the first horizontal transfer electrodes 37 as in the conventional example 2, and consequently the second vertical transfer electrodes 39 and the second horizontal transfer electrodes 40 with uniform film thicknesses can be obtained. Thus, according to Embodiment 3 also, it is possible to avoid an increase in the power consumption due to increased resistance variation in the second vertical transfer electrodes 39 and the second horizontal transfer electrodes 40.

Further, according to the solid-state imaging device manufacturing method according to Embodiment 3, in which isotropic etching is carried out, etching residues 224 as described in the "Description of Related Art" section with reference to FIG. 38B are prevented from being formed in the regions where the pixel separation parts 11c are formed. Therefore, the short-circuiting of the vertical transfer electrodes, black flows in images, etc., which tend to occur due to etching residues, can be prevented.

It should be noted that in Embodiment 3, like Embodiment 1, isotropic etching is carried out after anisotropic etching is carried out, but the method is not limited to this. In Embodiment 3 also, it is possible to carry out anisotropic etching after carrying out isotropic etching, like in Embodiment 2. In this case, the flatness of the second vertical transfer electrodes 39 and the second horizontal transfer electrodes 40 is improved.

Further, in Embodiment 3 also, the first and second transfer electrodes do not overlap each other in the semiconductor substrate 1 thickness direction in both of the vertical CCD 2 and horizontal CCD 3, but the embodiment is not limited to this. The embodiment may be such that the first transfer electrodes and the second transfer electrodes do not overlap each other in the semiconductor substrate thickness direction in only either the vertical CCD or the horizontal CCD. For instance, if the intent only is to facilitate the formation of the contact holes 14a for connection with the first vertical transfer electrodes 36, only the overlap of the first vertical transfer electrodes 36 and the second vertical transfer electrodes 39 may be avoided. Alternatively, if the intent only is to reduce the power consumption of the horizontal CCD 3, only the overlap of the first horizontal transfer electrodes 37 and the second horizontal transfer electrodes 40 may be avoided. One of such embodiments may be selected independently as required.

According to the present invention, it is possible to obtain a solid-state imaging device with decreased power consumption and with a high degree of freedom in layout design. Such a solid-state imaging device is usefully applicable in video cameras and digital still cameras, and hence, it has industrial applicability.

## Claims

1. A solid-state imaging device comprising a semiconductor substrate (1), the semiconductor substrate (1) including a charge transfer part (3; 4) for transferring signal charges, and a bus line part (16; 17) for supplying transfer pulses to the charge transfer part (3; 4), wherein
the charge transfer part (3; 4) includes:
a transfer channel (2a; 3a) formed in the semiconductor substrate (1);
a plurality of first transfer electrodes (6; 7) and a plurality of second transfer electrodes (9; 10) that are disposed on the transfer channel (2a; 3a) so as to cross the transfer channel (2a; 3a); and
shielding films (13; 20) formed on the first and second transfer electrodes (6, 9; 7, 10) so as to cover the transfer channel (2a; 3a), and
the bus line part (16; 17) includes a plurality of bus line wires (16a to 16d; 17a, 17b) for supplying different transfer pulses (ΦV1 to ΦV4; ΦH1, ΦH2) , respectively, each of the bus line wires (16a to 16d; 17a, 17b) being connected with the first transfer electrodes (6; 7) or the second transfer electrodes (9; 10),
wherein the plurality of first transfer electrodes (6; 7) and the plurality of second transfer electrodes (9; 10) are disposed so that the second transfer electrodes (9; 10) are positioned above the first transfer electrodes (6; 7), at least in a region overlapping a place where bus line wires (16a to 16d; 17a, 17b) are formed in a thickness direction of the semiconductor substrate (1), whereas the first transfer electrodes (6;. 7) and the second transfer electrodes (9; 10) are adjoined to each other in a region where the transfer channel (2a; 3a) is formed,
wherein a portion of each of the second transfer electrodes (9; 10) on the region where the transfer channel (2a; 3a) is formed does not overlap, in the thickness direction of the semiconductor substrate (1), at least the first transfer electrode (6; 7) to which is applied a transfer pulse different from that applied to the second transfer electrode (9; 10).

2. The solid-state imaging device according to claim 1, wherein a part of the charge transfer part constitutes a vertical charge transfer part (4) for transferring the signal charges in a vertical direction, wherein
a plurality of the transfer channels (2a) of the vertical charge transfer part (4) are disposed so as to extend in the vertical direction,
the first transfer electrodes (6) and the second transfer electrodes (9) of the vertical charge transfer part (4) are disposed so as to cross the plurality of the transfer channels (2a) of the vertical charge transfer part (4), and
the second transfer electrodes (9) of the vertical charge transfer part (4) are formed so that portions of the same in regions where the transfer channels (2a) of the vertical charge transfer part (4) are formed do not overlap the first transfer electrodes (6) of the vertical charge transfer part (2a) in the thickness direction of the semiconductor substrate (1).

3. The solid-state imaging device according to claim 2, wherein
the shielding films (13) of the vertical charge transfer part (4) are formed to cover the plurality of transfer channels (2a) of the vertical charge transfer part (4), respectively, and
the shielding films (13) are connected via contact holes (14a; 14b) with either the first transfer electrodes (6) or the second transfer electrodes (9) of the vertical charge transfer part (4), in the regions where the transfer channels (2a) are formed.

4. The solid-state imaging device according to claim 2 or 3, wherein the semiconductor substrate (1) further includes a plurality of photoelectric conversion parts (11a) for converting incident light into signal charges, the photoelectric conversion parts (11a) being arranged in vertical and horizontal directions in a matrix form on the semiconductor substrate (1).

5. The solid-state imaging device according to claim 4, wherein the semiconductor substrate (1) further includes pixel separation parts (11c) for separating the photoelectric conversion parts (11a) neighboring to each other in the vertical direction,
wherein the second transfer electrodes (9) of the vertical charge transfer part (4) are formed so that portions thereof in regions where the pixel separation parts (11c) are formed also do not overlap the first transfer electrodes (6) of the vertical transfer part (4) in the thickness direction of the semiconductor substrate (1).

6. The solid-state imaging device according to claim 1, wherein a part of the charge transfer part constitutes a horizontal charge transfer part (3) for transferring the signal charges in the horizontal direction, wherein
the transfer channel (3a) of the horizontal charge transfer part (3) is disposed to extend in the horizontal direction,
the first transfer electrodes (7) and the second transfer electrodes (10) of the horizontal charge transfer part (3) are disposed to cross the transfer channel (3a) of the horizontal charge transfer part (3), and
the second transfer electrodes (10) of the horizontal charge transfer part (3) are formed so that a portion of each of the same in a region where the transfer channel (3a) of the horizontal charge transfer part (3) is formed does not overlap, in the thickness direction of the semiconductor substrate (1), at least the first transfer electrode (7) of the horizontal charge transfer part (3) to which is applied a transfer pulse different from that applied to the second transfer electrode (10).

7. The solid-state imaging device according to claim 6, wherein the second transfer electrodes (10) of the horizontal charge transfer part (3) are formed so that a portion of each of the same in the region where the transfer channel (3a) of the horizontal charge transfer part (3) is formed does not overlap, in the thickness direction of the semiconductor substrate (1), the first transfer electrode (7) of the horizontal charge transfer part (3) to which a transfer pulse different from that applied to the second transfer electrode (10) is applied, and the first transfer electrode (7) of the horizontal charge transfer part (3) to which is applied the same transfer pulse as that applied to the second transfer electrode (10).

8. A method for manufacturing a solid-state imaging device including a semiconductor substrate (1), the semiconductor substrate (1) including a charge transfer part (3; 4) for transferring signal charges and a bus line part (16; 17) for supplying transfer pulses to the charge transfer part (3; 4), wherein the charge transfer part (3; 4) includes a transfer channel (2a; 3a) formed in the semiconductor substrate (1) as well as a plurality of first transfer electrodes (6; 7) and a plurality of second transfer electrodes (9; 10) that are disposed on the transfer channel (2a; 3a) so as to cross the transfer channel (2a; 3a), the method comprising the steps of:
(a) forming the transfer channel (2a; 3a) in the semiconductor substrate (1);
(b) forming a first conductive film on the semiconductor substrate (1) and patterning the first conductive film so as to form the plurality of first transfer electrodes (6; 7);
(c) forming first interlayer insulation films (8) around the first transfer electrodes (6; 7) for providing insulation between the first transfer electrodes (6; 7) and the second transfer electrodes (9; 10);
(d) forming a second conductive film (21) to cover the first transfer electrodes (6; 7) and the semiconductor substrate (1);
(e) patterning the second conductive film (21) so that the second conductive film (21) remain on the first transfer electrodes (6; 7) at least in a region overlapping a place where bus line wires (16a to 16d; 17a, 17b) are formed in a thickness direction of the semiconductor substrate (1); and, preferably after step (e),
(f) forming a resist pattern (23; 24) so that in a region where the transfer channel (2a; 3a) is formed, the resist pattern (23; 24) has openings such that portions of the second conductive film (21) overlapping the first interlayer insulation films (8) in the thickness direction of the semiconductor substrate (1) are not covered entirely or partially, and carrying out isotropic etching by using the resist pattern (23; 24) as a mask, so as to form the second transfer electrodes (9; 10).

9. The method according to claim 8, further comprising the steps of:
forming a plurality of photoelectric conversion parts (11a) in the semiconductor substrate (1), the photoelectric conversion parts (11a) being to convert incident light into signal charges, and being arranged in vertical and horizontal directions in a matrix form; and
forming pixel separation parts (11c) in the semiconductor substrate (1), the pixel separation parts (11c) being to separate the photoelectric conversion parts (11a) neighboring to each other in the vertical direction,
wherein in the step (f), the resist pattern (23; 24) is formed so that in regions where the pixel separation parts (11c) are formed also, the resist pattern (23; 24) has openings such that portions of the second conductive film (21) overlapping the first interlayer insulation films (8) in the thickness direction of the semiconductor substrate (1) are not covered, and the isotropic etching is carried out with use of the resist pattern (23; 24).

10. The method according to claim 8 or 9, further comprising the steps of:
forming a second interlayer insulation film (12) to cover the first transfer electrodes (6; 7) and the second transfer electrodes (9; 10);
forming a contact hole in the second interlayer insulation film (12) in the region where the transfer channel (2a; 3a) is formed, so that in a bottom of the contact hole either the first transfer electrode (6; 7) or the second transfer electrode (9; 10) is exposed;
filling the contact hole with a conductive material, and further forming a film of the conductive material over the second interlayer insulation film (12); and
patterning the film of the conductive material so as to form a shielding film to cover the transfer channel (2a; 3a).

11. Solid-state imaging device, in particular according to one of claims 1 to 7 or as manufactured according to one of claims 8 to 10, providing an increase in the degree of freedom in layout design while reducing the power consumption due to interlayer capacitances.
